# EUROPEAN PATENT APPLICATION

(11) **EP 4 586 777 A1**
(43) Date of publication of application: **16.07.2025**
(21) Application number: 23863141.0
(22) Date of filing: 04.09.2023
(51) Int. Cl.: H10K 30/50, H10K 30/40, H10K 30/86

(54) **SOLAR CELL ELEMENT, SOLAR CELL MODULE, AND METHOD FOR MANUFACTURING SOLAR CELL ELEMENT**

(30) Priority: 06.09.2022 JP 2022141521
(71) Applicant: Kyocera Corporation, Kyoto-shi, Kyoto 612-8501 (JP)
(72) Inventor: SANO, Hirotaka, Kyoto-shi, Kyoto 612-8501 (JP); FUJITA, Kohei, Kyoto-shi, Kyoto 612-8501 (JP); SATO, Ryo, Kyoto-shi, Kyoto 612-8501 (JP); NEMOTO, Yayoi, Kyoto-shi, Kyoto 612-8501 (JP)
(74) Representative: TBK
(86) International application number: PCT/JP2023/032232
(87) International publication number: WO 2024/053603

(57) **Abstract**

A solar cell device includes a first electrode (106), a photoelectric converter (104), and a first carrier transporter (105). The first carrier transporter (105) is located between the first electrode (106) and the photoelectric converter (104). The first carrier transporter (105) includes a first surface (CF1) in contact with the photoelectric converter (104) and a second surface (CF2) in contact with the first electrode (106). In the first carrier transporter (105), a first level (EL1) being an energy level of a highest occupied molecular orbital of a first interface area (Ab1) along the first surface (CF1) is lower than a second level (EL2) being an energy level of a highest occupied molecular orbital of a second interface area (Ab2) along the second surface (CF2).

## Description

### CROSS-REFERENCE TO RELATED APPLICATION

This application claims priority to Japanese Patent Application No. 2022-141521 filed on September 6, 2022, the entire disclosure of which is incorporated herein by reference.

### TECHNICAL FIELD

The present disclosure relates to a solar cell device, a solar cell module, and a method for manufacturing a solar cell device.

### BACKGROUND OF INVENTION

Patent Literature 1 describes a technique for the energy levels of an electron transport layer in a solar cell device. Solar cell devices and solar cell modules have been increasingly requested to improve power generation efficiency.

### CITATION LIST

### PATENT LITERATURE

Patent Literature 1: Japanese Unexamined Patent Application Publication No. 2022-31990

### SUMMARY

In one aspect, a solar cell device includes a first electrode, a photoelectric converter, and a first carrier transporter between the first electrode and the photoelectric converter. The first carrier transporter includes a first surface in contact with the photoelectric converter and a second surface in contact with the first electrode. In the first carrier transporter, a first level being an energy level of a highest occupied molecular orbital of a first interface area along the first surface is lower than a second level being an energy level of a highest occupied molecular orbital of a second interface area along the second surface.

In one aspect, a solar cell device includes a first electrode, a photoelectric converter, and a first carrier transporter between the first electrode and the photoelectric converter. The first carrier transporter includes a first surface in contact with the photoelectric converter and a second surface in contact with the first electrode. In the first carrier transporter, a carrier density in a first interface area along the first surface is greater than a carrier density in a second interface area along the second surface.

In one aspect, a solar cell module includes a first electrode, a photoelectric converter, and a first carrier transporter between the first electrode and the photoelectric converter. The first carrier transporter includes a first surface in contact with the photoelectric converter and a second surface in contact with the first electrode. In the first carrier transporter, a first level being an energy level of a highest occupied molecular orbital of a first interface area along the first surface is lower than a second level being an energy level of a highest occupied molecular orbital of a second interface area along the second surface.

In one aspect, a method for manufacturing a solar cell device includes forming a photoelectric converter, forming a first carrier transporter on the photoelectric converter, and forming a first electrode on the first carrier transporter. The forming the first carrier transporter includes forming a first layer, forming a second layer, and heating the first layer and the second layer. The forming the first layer includes forming the first layer on the photoelectric converter. The forming the second layer includes forming the second layer on the first layer. The heating the first layer and the second layer includes heating the first layer and the second layer to diffuse a dopant contained in the first layer into the second layer to produce the first carrier transporter from the first layer and the second layer. The first layer has a higher dopant concentration than the second layer. The second layer has a lower dopant concentration than the first layer or contains no dopant. The second layer contains a material for a semiconductor included in the first carrier transporter.

### BRIEF DESCRIPTION OF THE DRAWINGS

FIG. 1 is a schematic sectional view of a solar cell device with a first example structure according to a first embodiment.
FIG. 2 is an energy band diagram illustrating a first example relationship between the energy levels of a first electrode, a first carrier transporter, a photoelectric converter, and a second carrier transporter in the solar cell device according to the first embodiment.
FIG. 3 is a schematic sectional view of the solar cell device with a second example structure according to the first embodiment.
FIG. 4 is an energy band diagram illustrating a second example relationship between the energy levels of the first electrode, the first carrier transporter, the photoelectric converter, and the second carrier transporter in the solar cell device according to the first embodiment.
FIG. 5 is a schematic sectional view of the solar cell device with a third example structure according to the first embodiment.
FIG. 6 is an energy band diagram illustrating a third example relationship between the energy levels of the first electrode, the first carrier transporter, the photoelectric converter, and the second carrier transporter in the solar cell device according to the first embodiment.
FIG. 7 is a schematic sectional view of the solar cell device with a fourth example structure according to the first embodiment.
FIG. 8 is an energy band diagram illustrating a fourth example relationship between the energy levels of the first electrode, the first carrier transporter, the photoelectric converter, and the second carrier transporter in the solar cell device according to the first embodiment.
FIG. 9 is a flowchart of an example method for manufacturing the solar cell device according to the first embodiment.
FIG. 10 is a schematic sectional view of an example solar cell module according to the first embodiment.
FIG. 11 is a schematic sectional view of a solar cell device with a first example structure according to a second embodiment.
FIG. 12 is an energy band diagram illustrating a first example relationship between the energy levels of a first electrode, a first carrier transporter, a photoelectric converter, and a second carrier transporter in the solar cell device according to the second embodiment.
FIG. 13 is a flowchart of an example method for manufacturing the solar cell device according to the second embodiment.
FIG. 14 is a schematic sectional view of the solar cell device with a second example structure according to the second embodiment.
FIG. 15 is an energy band diagram illustrating a second example relationship between the energy levels of the first electrode, the first carrier transporter, the photoelectric converter, and the second carrier transporter in the solar cell device according to the second embodiment.
FIG. 16 is a schematic sectional view of the solar cell device with a third example structure according to the second embodiment.
FIG. 17 is an energy band diagram illustrating a third example relationship between the energy levels of the first electrode, the first carrier transporter, the photoelectric converter, and the second carrier transporter in the solar cell device according to the second embodiment.
FIG. 18 is a schematic sectional view of the solar cell device with a fourth example structure according to the second embodiment.
FIG. 19 is an energy band diagram illustrating a fourth example relationship between the energy levels of the first electrode, the first carrier transporter, the photoelectric converter, and the second carrier transporter in the solar cell device according to the second embodiment.

### DESCRIPTION OF EMBODIMENTS

For example, a solar cell device includes a first electrode, a first carrier transporter for transporting holes, a photoelectric converter, a second carrier transporter for transporting electrons, and a second electrode stacked in this order. Typically, the Fermi level and the energy level of the highest occupied molecular orbital or HOMO (hereafter also referred to as the HOMO level) of the first carrier transporter are constant or substantially constant across the thickness of the first carrier transporter.

Solar cell devices can have energy loss due to the barrier of energy (hereafter also simply referred to as the energy barrier) resulting from, for example, contact between a semiconductor and an electrode such as a metal or contact between semiconductors. Such energy loss is to be reduced. Ideally, the Fermi level of the first electrode, the Fermi level or the energy level of the HOMO (the HOMO level) of the first carrier transporter, and the energy level of the upper end of the valence band (valence band maximum or VBM) (hereafter also referred to as the VBM level) or the energy level of the HOMO (the HOMO level) of the photoelectric converter are matched.

However, these energy levels may not be matched. In such a case, the difference in energy level at an interface between the first electrode and the first carrier transporter and the difference in energy level at an interface between the first carrier transporter and the photoelectric converter may be reduced. The Fermi level and the HOMO level of the first carrier transporter are lower than or equal to the Fermi level of the first electrode and are higher than or equal to the VBM level or the HOMO level of the photoelectric converter.

Solar cell devices may have higher conversion efficiency when having higher photovoltaic performance. The photovoltaic performance is determined by the difference between the Fermi level of a material for the second carrier transporter and the Fermi level of a material for the first carrier transporter when the second carrier transporter, the photoelectric converter, the first carrier transporter, and the first electrode are not joined. Thus, to improve the photovoltaic performance of the solar cell device, the Fermi level and the HOMO level of the material for the first carrier transporter may be lowered toward the VBM level or the HOMO level of the material for the photoelectric converter.

However, the lower Fermi level and the HOMO level of the material for the first carrier transporter have a larger difference from the Fermi level of the material for the first electrode. This may increase the energy barrier at the interface between the first carrier transporter and the first electrode in the solar cell device. The solar cell device may thus have lower power generation efficiency.

To reduce the energy barrier at the interface between the first carrier transporter and the first electrode in the solar cell device, the Fermi level and the HOMO level of the material for the first carrier transporter may be adjusted toward the Fermi level of the material for the first electrode. This may reduce the difference between the Fermi level of the material for the second carrier transporter and the Fermi level of the material for the first carrier transporter. The solar cell device may thus have lower photovoltaic performance.

In short, the Fermi level and the HOMO level of the first carrier transporter typically have a constant or substantially constant distribution across the thickness of the first carrier transporter. Thus, improving the photovoltaic performance of solar cell devices while reducing energy loss due to the energy barrier at the interface between the first carrier transporter and the first electrode has been a challenge. Solar cell devices and solar cell modules are to be improved to have higher power generation efficiency.

The inventors of the present disclosure have developed a technique for improving power generation efficiency of solar cell devices and solar cell modules.

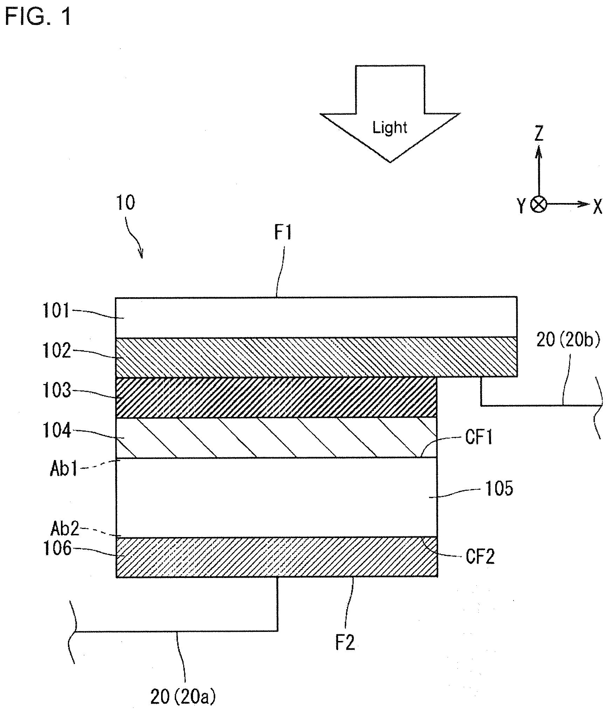

Embodiments of the present disclosure will now be described with reference to the drawings. In the drawings, the same reference numerals denote the components with the same or substantially the same structures and functions. Thus, such components will not be described repeatedly. The drawings are schematic. FIGs. 1, 3, 5, 7, 10, 11, 14, 16, and 18 each illustrate a right-handed XYZ coordinate system. In this XYZ coordinate system, a positive Z-direction refers to a normal direction to a first device surface F1 of a solar cell device 10 or 40. A positive X-direction refers to a direction parallel to the first device surface F1. A positive Y-direction refers to a direction parallel to the first device surface F1 and perpendicular to both the positive X-direction and the positive Z-direction.

### 1. First Embodiment

### 1-1. Solar Cell Device 10

The solar cell device 10 according to a first embodiment will now be described with reference to FIGs. 1 to 8. As illustrated in FIG. 1, the solar cell device 10 includes the surface (also referred to as a first device surface) F1 that mainly receives light and a surface (also referred to as a second device surface) F2 opposite to the first device surface F1. In the first embodiment, the first device surface F1 faces in the positive Z-direction. The second device surface F2 faces in a negative Z-direction. The positive Z-direction may be defined as, for example, a direction toward the sun culminating in the south.

As illustrated in FIG. 1, the solar cell device 10 includes a first electrode 106, a first carrier transporter 105, a photoelectric converter 104, a second carrier transporter 103, a second electrode 102, and a substrate 101. In the first embodiment, the second electrode 102, the second carrier transporter 103, the photoelectric converter 104, the first carrier transporter 105, and the first electrode 106 are stacked in this order on the substrate 101. The first carrier transporter 105 is thus located between the first electrode 106 and the photoelectric converter 104.

Note that, although not illustrated, the solar cell device 10 may include an anti-reflection film on a front surface of the solar cell device 10. The anti-reflection film may be an insulating film of, for example, silicon nitride. Although not illustrated, a passivation film may be located between the solar cell device 10 and the anti-reflection film. The passivation film may be a thin film of, for example, an oxide such as aluminum oxide or a nitride.

### 1-1-1. Substrate 101

The substrate 101 is, for example, a light-transmissive and insulating substrate. The substrate 101 transmits light in, for example, a specific wavelength range. The specific wavelength range includes a wavelength range of light absorbable by the photoelectric converter 104 to cause photoelectric conversion. More specifically, the specific wavelength range may include a visible light wavelength range of about 400 to 700 nanometers (nm) and an infrared light wavelength range of about 700 to 1200 nm. Thus, for example, light incident on the first device surface F1 may pass through the substrate 101 toward the photoelectric converter 104. When, for example, the specific wavelength range includes a wavelength of sunlight with high radiation intensity, the solar cell device 10 may have higher power generation efficiency. The material for the substrate 101 is, for example, glass, acryl, or polycarbonate. The substrate 101 may be, for example, a plate, a sheet, or a film. The substrate 101 may have a thickness of, for example, about 0.01 to 5 millimeters (mm).

### 1-1-2. Second Electrode 102

The second electrode 102 is located on the substrate 101. The second electrode 102 is located on a portion of the substrate 101 facing the second device surface F2. In other words, the second electrode 102 is located on a portion of the substrate 101 in the negative Z-direction.

The second electrode 102 can collect carriers resulting from photoelectric conversion in response to light incident on the photoelectric converter 104 (described later). The second electrode 102 can serve as, for example, an electrode (also referred to as a negative electrode) that collects electrons as carriers. The second electrode 102 may be formed on the substrate 101 with, for example, a vacuum process such as sputtering.

The second electrode 102 may be made of, for example, a transparent conductive oxide (TCO) that transmits light in a specific wavelength range. For example, the TCO may be, but is not limited to, an oxide such as indium tin oxide (ITO), aluminum-doped zinc oxide (AZO), boron-doped zinc oxide (BZO), gallium-doped zinc oxide (GZO), fluorine-doped tin oxide (FTO), antimony-doped tin oxide (ATO), titanium-doped indium oxide (ITiO), indium zinc oxide (IZO), indium gallium zinc oxide (IGZO), tantalum-doped tin oxide (SnO₂:Ta), niobium-doped tin oxide (SnO₂:Nb), tungsten-doped tin oxide (SnO₂:W), molybdenum-doped tin oxide (SnO₂:Mo), fluorine-doped tin oxide (SnO₂:F), or hydrogen-doped indium oxide (IOH). The second electrode 102 may include a TCO film. The TCO film may be a multilayer film including multiple films. Each of the multiple films may be, for example, a film of the oxide described above. The multiple films may each be, rather than a film of the oxide described above, a film of an oxide, such as tin oxide, containing dopants. The dopants may be one or more elements selected from the group consisting of indium (In), silicon (Si), germanium (Ge), titanium (Ti), copper (Cu), antimony (Sb), niobium (Nb), fluorine (F), tantalum (Ta), tungsten (W), molybdenum (Mo), bromine (Br), indium (I), and chlorine (Cl). 1-1-3. Second Carrier Transporter 103

The second carrier transporter 103 is located on the second electrode 102. The second carrier transporter 103 is located on a portion of the second electrode 102 facing the second device surface F2. In other words, the second carrier transporter 103 is located on a portion of the second electrode 102 in the negative Z-direction.

For example, the second carrier transporter 103 may be a semiconductor of an inorganic material (also referred to as an inorganic semiconductor) having higher electrical resistance than the second electrode 102. Thus, the second electrode 102 is less likely to be electrically in contact with the photoelectric converter 104.

In the first embodiment, the material for the inorganic semiconductor may be, for example, a semiconductor of n-type conductivity (also referred to as an n-type semiconductor). In this case, the second carrier transporter 103 functions as, for example, a hole blocking layer and an electron transport layer (ETL). The ETL can, for example, collect and output electrons.

The second carrier transporter 103 is made of metal oxide that transmits light in a specific wavelength range. Examples of the metal oxide may include titanium dioxide (TiO₂), tin dioxide (SnO₂), zinc oxide (ZnO), and indium oxide (In₂O₃). The metal oxide may be doped with, for example, an n-type dopant. When the metal oxide is ZnO, for example, the n-type dopant may be, for example, aluminum (Al) or boron (B). The second electrode 102 may have a thickness of, for example, about 10 to 50 nm. For example, the second carrier transporter 103 may be formed on the second electrode 102 by applying, onto the second electrode 102, a liquid material prepared by dissolving a material such as metal chloride or metal isopropoxide into a polar solution, and hydrolyzing the material to produce the metal oxide. Examples of the metal chloride include titanium chloride, tin chloride, zinc chloride, and indium chloride. Examples of metal isopropoxide include titanium isopropoxide, tin isopropoxide, zinc isopropoxide, and indium isopropoxide.

### 1-1-4. Photoelectric Converter 104

The photoelectric converter 104 is located on the second carrier transporter 103. The photoelectric converter 104 is located on a portion of the second carrier transporter 103 facing the second device surface F2. In other words, the photoelectric converter 104 is located on a portion of the second carrier transporter 103 in the negative Z-direction.

The photoelectric converter 104 can absorb light passing through the substrate 101, the second electrode 102, and the second carrier transporter 103. In the first embodiment, the photoelectric converter 104 is, for example, an intrinsic semiconductor (also referred to as an i-type semiconductor). The i-type semiconductor may be a semiconductor with a perovskite structure (also referred to as a perovskite semiconductor).

The perovskite semiconductor may include, for example, an organic and inorganic halide perovskite semiconductor. The organic and inorganic halide perovskite semiconductor is a semiconductor with a perovskite structure of a composition of ABX₃. Examples of A in ABX₃ described above include an ion of at least one selected from the group consisting of methylammonium (CH₃NH₃), formamidinium (CH(NH₂)₂), cesium (Cs), rubidium (Rb), and potassium (K). Examples of B in ABX₃ described above include an ion of at least one selected from the group consisting of lead (Pb) and tin (Sn). Examples of X in ABX₃ described above include an ion of at least one selected from the group consisting of iodine (I), bromine (Br), and chlorine (Cl). More specifically, the semiconductor with the perovskite structure of the ABX₃ composition may include, for example, organic perovskite such as CH₃NH₃PbI₃ or (CH(NH₂)₂,Cs)Pb(I,Br)₃. The organic perovskite may be formed by, for example, applying a first liquid material onto the second carrier transporter 103 and drying the applied liquid material. In this example, the organic perovskite may be a crystalline thin film. The first liquid material may be prepared by, for example, dissolving alkyl halide amine and lead halide as the materials in a solvent. The photoelectric converter 104 may have a thickness of, for example, about 100 to 2000 nm. The energy level of the VBM (the VBM level) of the photoelectric converter 104 is hereafter referred to as a third level EL3.

### 1-1-5. First Carrier Transporter 105

The first carrier transporter 105 is located on the photoelectric converter 104. The first carrier transporter 105 is located on a portion of the photoelectric converter 104 facing the second device surface F2. In other words, the first carrier transporter 105 is located on a portion of the photoelectric converter 104 in the negative Z-direction.

In the first embodiment, the first carrier transporter 105 may be, for example, a semiconductor having p-type conductivity (also referred to as a p-type semiconductor). In this case, the first carrier transporter 105 functions as, for example, an electron blocking layer and a hole transport layer (HTL). For example, the HTL can collect and output holes.

The first carrier transporter 105 may be made of, for example, 2,2',7,7'-tetrakis-(N,N-di-4-methoxyphenylamino)-9,9'-spirobifluorene (spiro-OMeTAD), which is a derivative of soluble diamine. The first carrier transporter 105 may be formed by, for example, applying a second liquid material onto a layer of a perovskite semiconductor as the photoelectric converter 104 and drying the applied second liquid material. The carrier transport layer may have a thickness of, for example, about 50 to 200 nm.

The first carrier transporter 105 may also be made of, for example, poly[bis(4-phenyl)(2,4,6-trimethylphenyl)amine] (PTAA), poly(3-hexylthiophene-2,5-diyl) (P3HT), or poly(3,4-ethylenedioxythiophene)/poly(4-styrenesulfonate) (PEDOT/PSS).

The first carrier transporter 105 includes a surface (also referred to as a first surface) CF1 in contact with the photoelectric converter 104 and a surface (also referred to as a second surface) CF2 in contact with the first electrode 106. Hereafter, the energy level of the HOMO (the HOMO level) of an area (also referred to as a first interface area) Ab1 along the first surface CF1 of the first carrier transporter 105 is referred to as a first level EL1. The energy level of the HOMO (the HOMO level) of an area (also referred to as a second interface area) Ab2 along the second surface CF2 of the first carrier transporter 105 is referred to as a second level EL2.

The first interface area Ab1 may be an area of the first carrier transporter 105 along the first surface CF1. The first interface area Ab1 may have a predetermined thickness in the negative Z-direction as a first direction from the first surface CF1 toward the second surface CF2. The predetermined thickness may be determined based on, for example, the spatial resolution of a device for HOMO level measurement. When the device for HOMO level measurement performs predetermined etching on a surface of a measurement target sample to measure HOMO levels in a thickness direction of the measurement target sample, the predetermined thickness may be determined based on, for example, errors in the etching rate or the time resolution of etching operations. The predetermined thickness may be, for example, 5, 3, 1, 0.5, 0.3, or 0.1 nm.

The second interface area Ab2 may be an area of the first carrier transporter 105 along the second surface CF2. The second interface area Ab2 may have a predetermined thickness in the positive Z-direction as a second direction opposite to the first direction. The predetermined thickness may be determined based on, for example, the spatial resolution of a device for HOMO level measurement. When the device for HOMO level measurement performs predetermined etching on a surface of a measurement target sample to measure HOMO levels in a thickness direction of the measurement target sample, the predetermined thickness may be determined based on, for example, errors in the etching rate or the time resolution of etching operations. The predetermined thickness may be, for example, 5, 3, 1, 0.5, 0.3, or 0.1 nm.

### 1-1-6. First Electrode 106

The first electrode 106 is located on the first carrier transporter 105. The first electrode 106 is located on a portion of the first carrier transporter 105 facing the second device surface F2. In other words, the first electrode 106 is located on a portion of the first carrier transporter 105 in the negative Z-direction.

The first electrode 106 can collect carriers resulting from photoelectric conversion in response to light incident on the photoelectric converter 104. The material for the first electrode 106 is, for example, a highly conductive metal such as gold (Au), or a TCO. Examples of the TCO include ITO, FTO, and ZnO. The first electrode 106 may be, for example, a layered electrode (also referred to as a first electrode layer). The first electrode 106 may have a thickness of, for example, about 10 to 1000 nm. The first electrode 106 may be formed on the first carrier transporter 105 with, for example, a vacuum process such as sputtering. When TCO is used as the material for the first electrode 106, for example, the first electrode 106 transmits light in a specific wavelength range. In this case, for example, light incident on the second device surface F2 may pass through the first electrode 106 to reach the photoelectric converter 104. Thus, in addition to the first device surface F1, the second device surface F2 can be the light-receiving surface of the solar cell device 10. Hereafter, the Fermi level of the first electrode 106 is referred to as a fourth level EL4.

Each of the first electrode 106 and the second electrode 102 may be electrically connected to, for example, a wire 20 such as a lead wire. More specifically, for example, a first wire 20a is electrically connected to the first electrode 106, and a second wire 20b is electrically connected to the second electrode 102. Each wire 20 may be joined to the corresponding one of the first electrode 106 and the second electrode 102 by, for example, soldering. For example, the solar cell device 10 can obtain outputs resulting from photoelectric conversion through the first wire 20a and the second wire 20b.

### 1-2. Energy Band Structure of First Carrier Transporter 105

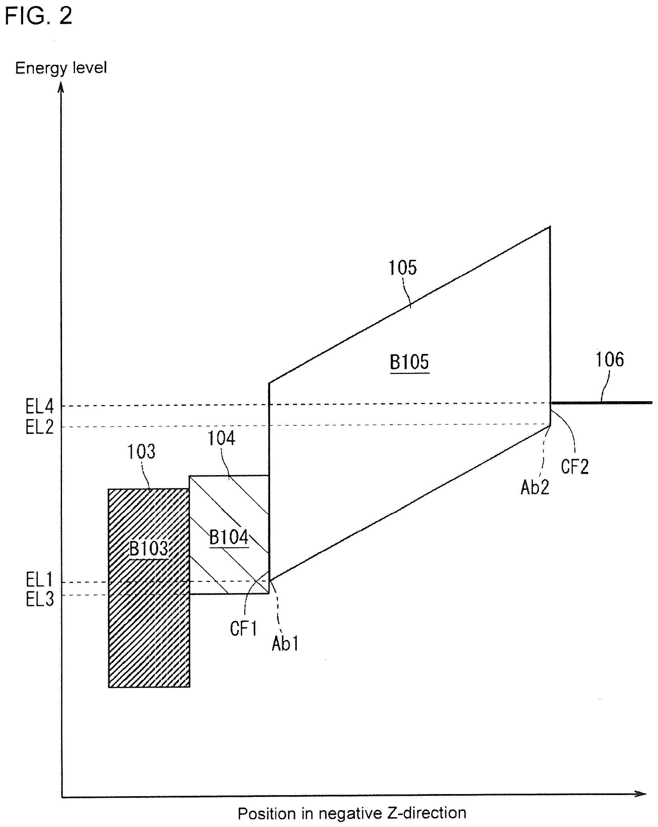

In the first embodiment, the first carrier transporter 105 in the solar cell device 10 may have, for example, an energy band structure as illustrated in FIG. 2. In FIG. 2, the horizontal axis indicates the position in the negative Z-direction, and the vertical axis indicates the energy level. FIG. 2 illustrates the energy levels in a forbidden band B103 of the second carrier transporter 103, the energy levels in a forbidden band B104 of the photoelectric converter 104, the energy levels in a forbidden band B105 of the first carrier transporter 105, and the Fermi level of the first electrode 106 in this order from the left to the right.

In the first carrier transporter 105, the first level EL1, which is the HOMO level of the first interface area Ab1 along the first surface CF1 in contact with the photoelectric converter 104, is different from the second level EL2, which is the HOMO level of the second interface area Ab2 along the second surface CF2 in contact with the first electrode 106.

In one example, the HOMO level of the first carrier transporter 105 is substantially constant across the thickness. In this case, to achieve higher photovoltaic performance, the HOMO level of the material for the first carrier transporter 105 may be adjusted toward the VBM level of the photoelectric converter 104 when the second carrier transporter 103, the photoelectric converter 104, the first carrier transporter 105, and the first electrode 106 are not joined. However, this may increase the difference between the HOMO level of the material for the first carrier transporter 105 and the Fermi level of the material for the first electrode 106. Thus, the energy barrier between the first carrier transporter 105 and the first electrode 106 may be greater in the resulting solar cell device 10. The HOMO level of the material for the first carrier transporter 105 may be adjusted toward the Fermi level of the first electrode 106 to reduce the energy barrier between the first carrier transporter 105 and the first electrode 106 in the solar cell device 10, with the second carrier transporter 103, the photoelectric converter 104, the first carrier transporter 105, and the first electrode 106 being not joined. However, this structure may reduce the difference between the HOMO level of the material for the first carrier transporter 105 and the Fermi level of the second carrier transporter 103. In other words, the structure may reduce the difference between the Fermi level of the first carrier transporter 105 and the Fermi level of the second carrier transporter 103. The solar cell device 10 may thus have lower photovoltaic performance.

In another example, the first level EL1 is different from the second level EL2 as described above. In this case, for example, the second level EL2 can be changed without changing the first level EL1. For example, the first level EL1 may be changed without changing the second level EL2. In other words, for example, the first level EL1 can be adjusted toward the third level EL3 that is the VBM level of the photoelectric converter 104, with the second level EL2 being close to the fourth level EL4 that is the Fermi level of the first electrode 106. For example, the second level EL2 can be adjusted toward the fourth level EL4 that is the Fermi level of the first electrode 106, with the first level EL1 being close to the third level EL3 that is the VBM level of the photoelectric converter 104. Thus, photovoltaic performance can be higher without increasing the energy barrier between the first carrier transporter 105 and the first electrode 106. In other words, the energy barrier between the first carrier transporter 105 and the first electrode 106 can be reduced without lowering the photovoltaic performance.

The HOMO level of the first carrier transporter 105 may be measured with, for example, ultraviolet photoelectron spectroscopy (UPS). With UPS, the HOMO level may be estimated based on the position at which the spectrum of detected photoelectrons rises. The HOMO level may thus be identified. As with the HOMO level, the VBM level of the photoelectric converter 104 may also be measured with, for example, UPS. In this case, the VBM level may be estimated based on the position at which the spectrum of detected photoelectrons rises. The VBM level may thus be identified. The HOMO levels and the VBM levels of different portions may be measured with another measurement method such as X-ray photoelectron spectroscopy (XPS). The distribution of HOMO levels in a depth direction of a sample may be measured by performing measurement using UPS or XPS while etching a surface of the sample with, for example, gas cluster ion beams (GCIB). The Fermi level of the first electrode 106 may be measured with, for example, UPS. With UPS, the Fermi level may be estimated based on the position at which the spectrum of detected photoelectrons rises. The Fermi level may thus be identified. The Fermi level of the first electrode 106 may be measured with another measurement method such as XPS.

In embodiments of the present disclosure, two energy levels being different from each other refer to the absolute value of the difference between the two energy levels being greater than or equal to a predetermined value. The absolute value of the difference between two energy levels being less than the predetermined value may refer to the two energy levels being equal to each other. The absolute value of the difference between two energy levels being less than the predetermined value may also refer to the two energy levels being substantially the same. Two energy levels being substantially the same may be equivalent to the two energy levels being practically the same. The predetermined value may be determined based on, for example, measurement errors of a measurement device for measuring energy levels, such as a UPS or XPS device. In this case, the predetermined value may be, for example, 0.1 electron volt (eV). In other words, two energy levels being substantially the same may be equivalent to, for example, the absolute value of the difference of the two energy levels being less than 0.1 eV, which is the predetermined value.

In the first carrier transporter 105, the dopant concentration can be changed to change the HOMO level of the first carrier transporter 105. In other words, in the first carrier transporter 105, the carrier density can be changed to change the HOMO level of the first carrier transporter 105. In other words, the carrier concentration in the first carrier transporter 105 may be changed by changing the dopant concentration in the first carrier transporter 105. The dopant concentration in the first carrier transporter 105 may decrease, for example, from the first surface CF1 toward the second surface CF2. More specifically, the dopant concentration in the first carrier transporter 105 may decrease, for example, from the first interface area Ab1 along the first surface CF1 toward the second interface area Ab2 along the second surface CF2. In other words, when an X-Z section of the solar cell device 10 is viewed as illustrated in FIG. 1, the dopant concentration in the first carrier transporter 105 may decrease in the negative Z-direction, for example. The dopant concentration may be defined as, for example, the number of dopant atoms per unit volume or the mole number (mol) of the dopant per unit volume. The dopant concentration in the first carrier transporter 105 may be changed by, for example, diffusing the dopant in a layer of the material for a semiconductor included in the first carrier transporter 105 from the first surface CF1 toward the second surface CF2. The change of the dopant concentration in the first carrier transporter 105 may be controlled by, for example, selection of the dopant material or by the conditions for diffusing the dopant in the layer of the semiconductor material when forming the first carrier transporter 105. In other words, for example, the conditions for forming the first carrier transporter 105 may control the change of the dopant concentration in the first carrier transporter 105.

In the first carrier transporter 105 in the solar cell device 10 according to the first embodiment, the first level EL1 is lower than the second level EL2. Typically, the third level EL3 of the photoelectric converter 104 is lower than the fourth level EL4 of the first electrode 106. Thus, the first level EL1 of the first carrier transporter 105 being lower than the second level EL2 can reduce the difference between the second level EL2 and the fourth level EL4 while reducing the difference between the first level EL1 and the third level EL3. In other words, the first level EL1 of the first carrier transporter 105 being lower than the second level EL2 can reduce the difference between the first level EL1 and the third level EL3, with the difference between the second level EL2 and the fourth level EL4 being small. This can improve the photovoltaic performance of the solar cell device 10 while reducing the energy barrier between the first carrier transporter 105 and the first electrode 106. In other words, the energy barrier between the first carrier transporter 105 and the first electrode 106 can be reduced while allowing the solar cell device 10 to have higher photovoltaic performance. The solar cell device 10 can thus have higher power generation efficiency.

In the first carrier transporter 105 in the solar cell device 10 according to the first embodiment, for example, the HOMO level of the first carrier transporter 105 may increase from the first surface CF1 toward the second surface CF2 in the first direction. In other words, in the first carrier transporter 105, for example, the HOMO level may increase from the first interface area Ab1 along the first surface CF1 toward the second interface area Ab2 along the second surface CF2 in the first direction. The HOMO level of the first carrier transporter 105 may increase continuously or discretely. In a graph showing the distribution of HOMO levels of the first carrier transporter 105 in the first direction, for example, the HOMO level of the first carrier transporter 105 may increase monotonically in the first direction. In this case, the rate of the HOMO level change in the first direction may or may not be constant. The rate of the HOMO level change in the first direction may be a value resulting from dividing the amount of the HOMO level change corresponding to an amount of positional change in the first direction by the amount of positional change in the first direction. In the graph showing the distribution of HOMO levels of the first carrier transporter 105 in the first direction, for example, the HOMO level of the first carrier transporter 105 may increase stepwise in the first direction. When the HOMO level of the first carrier transporter 105 increases in the first direction, the graph showing the distribution of HOMO levels of the first carrier transporter 105 in the first direction is not recessed in a direction toward higher energy levels between the first surface CF1 and the second surface CF2. When the graph showing the distribution of HOMO levels of the first carrier transporter 105 in the first direction is recessed in the direction toward higher energy levels, the recessed portion may block carrier movements, and the solar cell device 10 may have lower power generation efficiency. However, with the HOMO level of the first carrier transporter 105 increasing in the first direction, holes as carriers can move more easily in the first carrier transporter 105. Thus, the solar cell device 10 is less likely to have lower power generation efficiency.

In the first carrier transporter 105 in the solar cell device 10 according to the first embodiment, for example, the first level EL1 is substantially the same as the third level EL3. In other words, the absolute value of the difference between the first level EL1 and the third level EL3 is less than or equal to a predetermined value. As described above, the predetermined value may be determined based on, for example, measurement errors of the measurement device for measuring energy levels, such as an UPS or XPS device. In this case, the predetermined value may be, for example, 0.1 eV. When the first level EL1 is substantially the same as the third level EL3, the energy barrier between the first carrier transporter 105 and the photoelectric converter 104 may be reduced.

In the first carrier transporter 105 in the solar cell device 10 according to the first embodiment, for example, the first level EL1 may be higher than and substantially the same as the third level EL3. In this case, the first level EL1 is higher than the third level EL3. Thus, holes as carriers can move more easily from the photoelectric converter 104 to the first carrier transporter 105. This movement occurs because, in contrast to negatively charged electrons that tend to move toward lower energy levels, positively charged (opposite to negatively charged) holes tend to move toward higher energy levels.

In the first carrier transporter 105 in the solar cell device 10 according to the first embodiment, for example, the second level EL2 may be substantially the same as the fourth level EL4. In other words, the absolute value of the difference between the second level EL2 and the fourth level EL4 may be less than or equal to a predetermined value. As described above, the predetermined value may be determined based on, for example, measurement errors of the measurement device for measuring energy levels, such as an UPS or XPS device. In this case, the predetermined value may be, for example, 0.1 eV. When the second level EL2 is substantially the same as the fourth level EL4, the energy barrier between the first carrier transporter 105 and the first electrode 106 may be reduced.

In the first carrier transporter 105 in the solar cell device 10 according to the first embodiment, for example, the second level EL2 may be lower than and substantially the same as the fourth level EL4. In this case, the fourth level EL4 is higher than the second level EL2. Thus, holes as carriers can move more easily from the first carrier transporter 105 to the first electrode 106. This movement occurs because, in contrast to negatively charged electrons that tend to move toward lower energy levels, positively charged (opposite to negatively charged) holes tend to move toward higher energy levels.

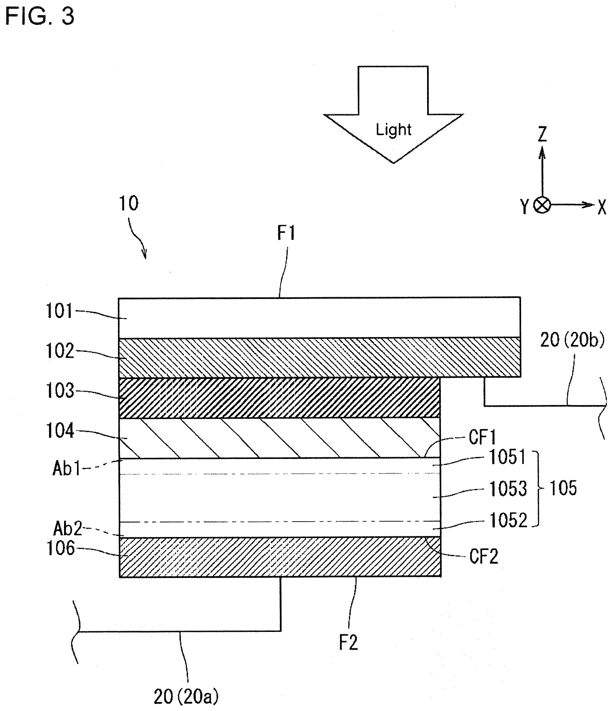

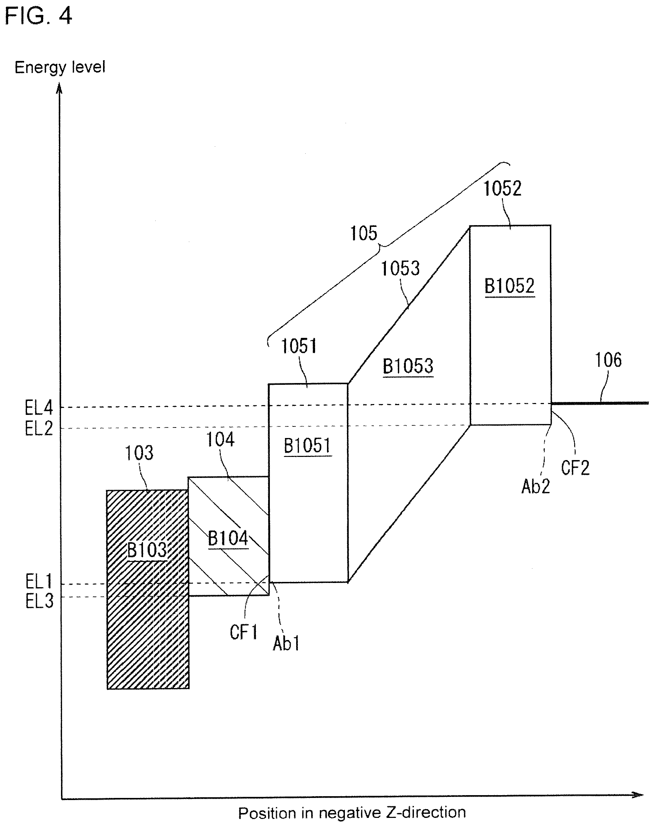

In the first carrier transporter 105 in the solar cell device 10 according to the first embodiment, as illustrated in FIG. 3, the first carrier transporter 105 may include, for example, a first area 1051 located along the first surface CF1. The first area 1051 has a first predetermined thickness from the first surface CF1 in the negative Z-direction as the first direction. The first area 1051 includes the first surface CF1. The first area 1051 is in contact with the photoelectric converter 104 on the first surface CF1. In this case, the first carrier transporter 105 in the solar cell device 10 according to the first embodiment may have, for example, an energy band structure as illustrated in FIG. 4. In the energy band diagram in FIG. 4, the energy levels in the forbidden band B105 of the first carrier transporter 105 illustrated in the energy band diagram in FIG. 2 is replaced with the energy levels in a forbidden band B1051 of the first area 1051, the energy levels in a forbidden band B1053 of a third area 1053 (described later), and the energy levels of a forbidden band B1052 of a second area 1052 (described later) in this order from the left to the right. The HOMO level of the first area 1051 may be substantially the same as the third level EL3. In other words, in the first carrier transporter 105, the HOMO level may be substantially the same as the third level EL3 in a portion extending from the first surface CF1 in the first direction by the first predetermined thickness. In still other words, the HOMO level of the first area 1051 may be substantially the same as the third level EL3 in the negative Z-direction as the first direction. In this example, although the HOMO level of the first carrier transporter 105 increases in the negative Z-direction as the first direction, the solar cell device 10 including the first carrier transporter 105 with the first area 1051 can have lower decrease in the photovoltaic performance than when not including the first area 1051.

As described above, the photovoltaic performance of the solar cell device 10 is proportional to the difference between the Fermi level of the material for the first carrier transporter 105 and the Fermi level of the material for the second carrier transporter 103. The Fermi level of the material for the first carrier transporter 105, which contributes to the photovoltaic performance, may be approximate to an average of Fermi levels in, for example, an area of the first carrier transporter 105 in contact with photoelectric converter 104 (also referred to as a first contact area) when the second carrier transporter 103, the photoelectric converter 104, the first carrier transporter 105, and the first electrode 106 are not joined. The first contact area may have a thickness of, for example, 1 nm or more and less than 100 nm in the negative Z-direction as the first direction. Thus, when the HOMO level of the first carrier transporter 105 increases in the negative Z-direction as the first direction in the first contact area, for example, the Fermi level of the first carrier transporter 105 may also increase, similarly to the HOMO level, in the negative Z-direction as the first direction. This may increase the average of Fermi levels in the area of the first carrier transporter 105 in contact with the photoelectric converter 104 (the first contact area). Thus, the difference between the Fermi level of the first carrier transporter 105 and the Fermi level of the second carrier transporter 103, which contributes to the determination of the photovoltaic performance, may be smaller when the second carrier transporter 103, the photoelectric converter 104, the first carrier transporter 105, and the first electrode 106 are not joined. The solar cell device 10 may thus have lower photovoltaic performance.

However, for example, when the first carrier transporter 105 includes the first area 1051 described above, the average of Fermi levels in the area of the first carrier transporter 105 in contact with the photoelectric converter 104 (the first contact area) may be substantially the same as the third level EL3. Thus, although the HOMO level of the first carrier transporter 105 increases in the negative Z-direction as the first direction, the first carrier transporter 105 including the first area 1051 described above may reduce, by a smaller amount, the difference between the Fermi level of the first carrier transporter 105 and the Fermi level of the second carrier transporter 103, which contributes to the determination of the photovoltaic performance when the second carrier transporter 103, the photoelectric converter 104, the first carrier transporter 105, and the first electrode 106 are not joined. The solar cell device 10 may thus have a smaller reduction in the photovoltaic performance.

The first predetermined thickness may be, for example, 10 nm or more. In this manner, when the first predetermined thickness is not too thin, the average of Fermi levels in an area of the first carrier transporter 105 in contact with the photoelectric converter 104 (the first contact area) may be substantially the same as the third level EL3. The first predetermined thickness may also be, for example, 100 nm or less. In this manner, when the first predetermined thickness is not too thick, a second area 1052 (described later) may not be too thin in the first carrier transporter 105, and the energy barrier between the first carrier transporter 105 and the first electrode 106 may be less likely to be greater.

In the first carrier transporter 105 in the solar cell device 10 according to the first embodiment, as illustrated in FIG. 3, the first carrier transporter 105 may include, for example, the second area 1052 along the second surface CF2. The second area 1052 has a second predetermined thickness from the second surface CF2 in the positive Z-direction as the second direction opposite to the first direction. The second area 1052 includes the second surface CF2. The second area 1052 is in contact with the first electrode 106 on the second surface CF2. In this case, the HOMO level of the second area 1052 may be, for example, substantially the same as the fourth level EL4 as illustrated in FIG. 4. In other words, in the first carrier transporter 105, the HOMO level may be substantially the same as the fourth level EL4 in a portion extending from the second surface CF2 in the second direction by the second predetermined thickness. In still other words, the HOMO level of the second area 1052 may be substantially the same as the fourth level EL4 in the positive Z-direction as the second direction. In this example, although the HOMO level of the first carrier transporter 105 increases in the negative Z-direction as the first direction, the first carrier transporter 105 including the second area 1052 may have a smaller energy barrier with the first electrode 106 than when not including the second area 1052.

As described above, the magnitude of the energy barrier between the first carrier transporter 105 and the first electrode 106 may be determined based on the difference between the HOMO level of the material for the first carrier transporter 105 and the Fermi level of the material for the first electrode 106 when the second carrier transporter 103, the photoelectric converter 104, the first carrier transporter 105, and the first electrode 106 are not joined. When the second carrier transporter 103, the photoelectric converter 104, the first carrier transporter 105, and the first electrode 106 are not joined, the HOMO level of the material for the first carrier transporter 105, which contributes to the determination of the magnitude of the energy barrier between the first carrier transporter 105 and the first electrode 106, may be approximate to, for example, an average HOMO level of an area of the first carrier transporter 105 in contact with the first electrode 106 (also referred to as a second contact area). The second contact area may have a thickness of, for example, 1 nm or more and less than 100 nm in the positive Z-direction as the second direction. Thus, when the HOMO level of the first carrier transporter 105 increases in the negative Z-direction as the first direction in the second contact area, for example, the average HOMO level of the first carrier transporter 105 may decrease. Thus, the difference between the HOMO level of the area of the first carrier transporter 105 in contact with the first electrode 106 (the second contact area) and the Fermi level of the first electrode 106 may be greater when the second carrier transporter 103, the photoelectric converter 104, the first carrier transporter 105, and the first electrode 106 are not joined. This may increase the energy barrier between the first carrier transporter 105 and the first electrode 106 in response to an increase in the difference between the HOMO level of the area of the first carrier transporter 105 in contact with the first electrode 106 (the second contact area) and the Fermi level of the first electrode 106.

However, when the first carrier transporter 105 includes the second area 1052 described above, for example, the average HOMO level of the area of the first carrier transporter 105 in contact with the first electrode 106 (the second contact area) may be substantially the same as the fourth level EL4. Thus, although the HOMO level of the first carrier transporter 105 increases in the negative Z-direction as the first direction, the first carrier transporter 105 including the second area 1052 may increase, by a smaller amount, the difference between the HOMO level of the first carrier transporter 105 and the Fermi level of the first electrode 106, which contributes to the determination of the magnitude of the energy barrier between the first carrier transporter 105 and the first electrode 106 when the second carrier transporter 103, the photoelectric converter 104, the first carrier transporter 105, and the first electrode 106 are not joined. The solar cell device 10 may thus have a smaller energy barrier between the first carrier transporter 105 and the first electrode 106.

The second predetermined thickness may be, for example, 10 nm or more. In this manner, when the second predetermined thickness is not too thin, the average HOMO level of the area of the first carrier transporter 105 in contact with the first electrode 106 (the second contact area) may be substantially the same as the fourth level EL4. The second predetermined thickness may also be, for example, 100 nm or less. In this manner, when the second predetermined thickness is not too thick, the first area 1051 described above may not be too thin in the first carrier transporter 105, and the photovoltaic performance of the solar cell device 10 may be lower by a smaller amount.

In the first carrier transporter 105 in the solar cell device 10 according to the first embodiment, the first carrier transporter 105 may include, for example, a third area 1053 between the first area 1051 and the second area 1052 as illustrated in FIG. 3. In this case, the HOMO level of the third area 1053 may increase, for example, in the negative Z-direction as the first direction as illustrated in FIG. 4. The HOMO level of the first carrier transporter 105 may increase continuously or discretely. In a graph showing the distribution of HOMO levels of the first carrier transporter 105 in the first direction, for example, the HOMO level of the first carrier transporter 105 may increase monotonically in the first direction. In a graph showing the distribution of HOMO levels of the first carrier transporter 105 in the first direction, for example, the HOMO level of the first carrier transporter 105 may increase stepwise in the first direction. When the HOMO level of the first carrier transporter 105 increases in the first direction, the graph showing the distribution of HOMO levels of the first carrier transporter 105 in the first direction is not recessed in a direction toward higher energy levels between the first area 1051 and the second area 1052. When the graph showing the distribution of HOMO levels of the first carrier transporter 105 in the first direction is recessed in a direction toward higher energy levels, the recessed portion may block carrier movements, and the solar cell device 10 may have lower conversion efficiency. However, with the HOMO level of the third area 1053 of the first carrier transporter 105 increasing in the first direction, holes as carriers can move more easily in the first carrier transporter 105. The solar cell device 10 is thus less likely to have lower conversion efficiency.

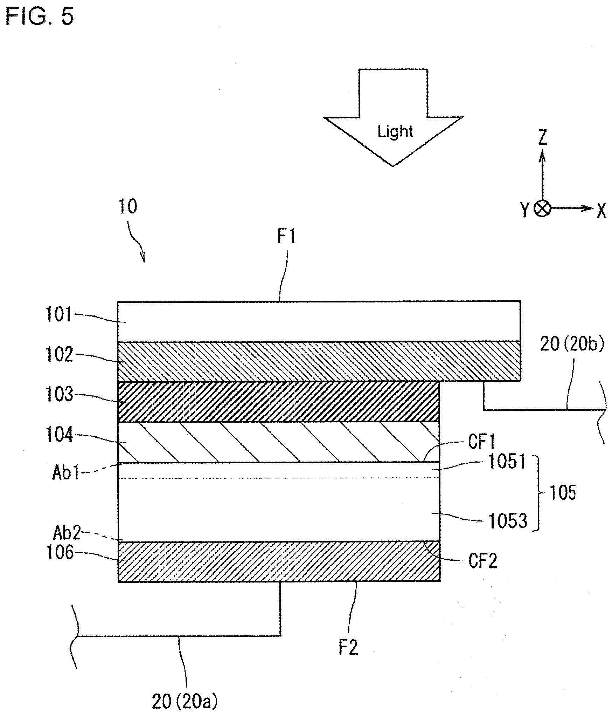

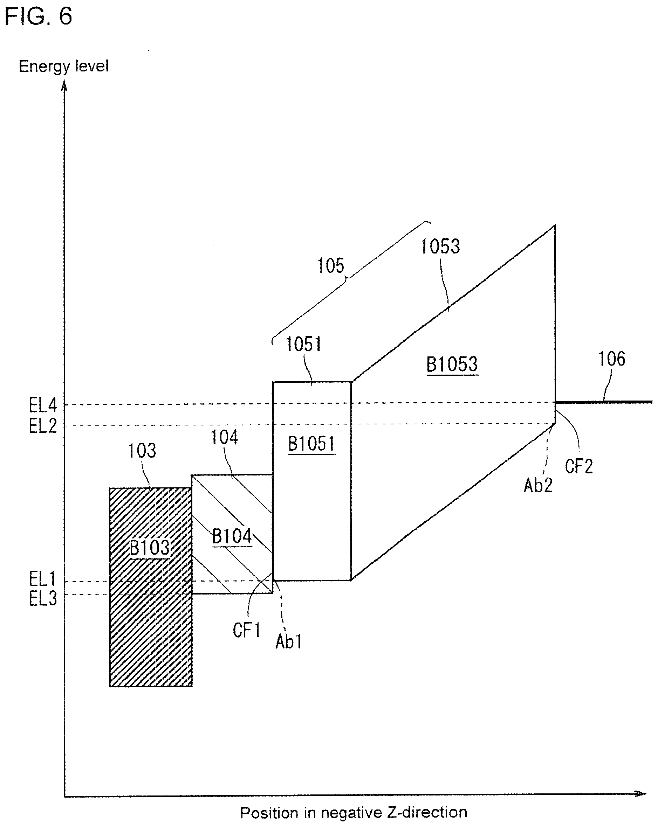

Note that, in the first carrier transporter 105 in the solar cell device 10 according to the first embodiment, the first carrier transporter 105 may include, for example, no second area 1052 between the third area 1053 and the first electrode 106 as illustrated in FIG. 5. In other words, for example, the first carrier transporter 105 may include the third area 1053 between the first area 1051 and the first electrode 106. In this case, the first carrier transporter 105 in the solar cell device 10 according to the first embodiment may have, for example, an energy band structure as illustrated in FIG. 6. In the energy band diagram in FIG. 6, the energy levels in the forbidden band B1052 of the second area 1052 in the energy band diagram in FIG. 4 are eliminated.

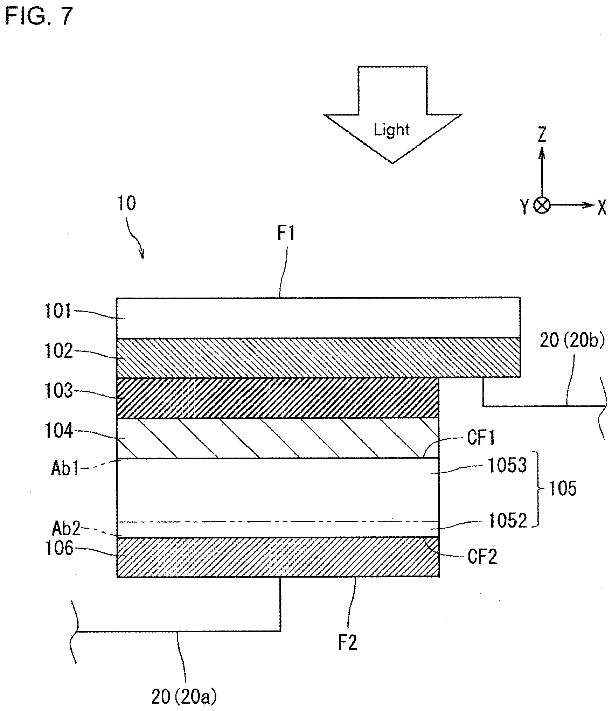

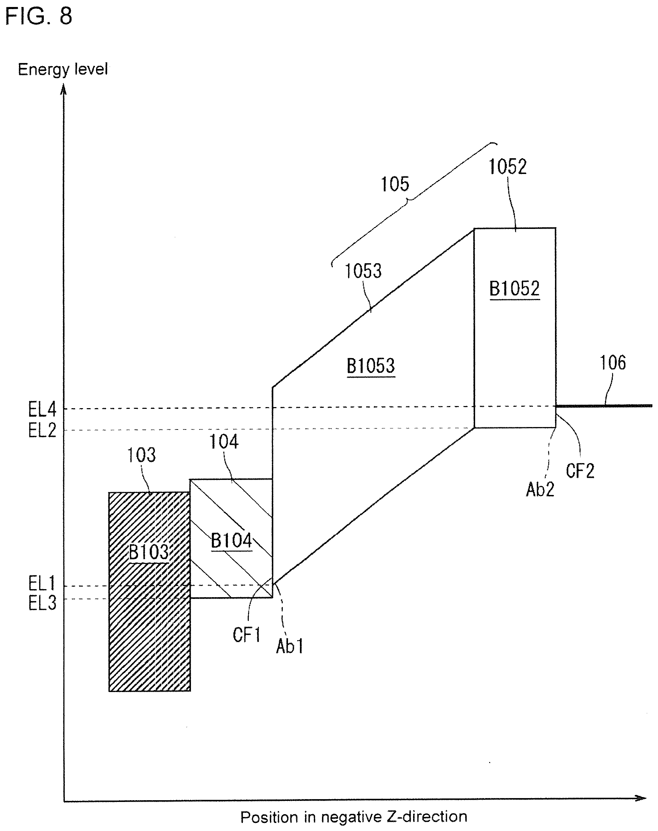

In the first carrier transporter 105 in the solar cell device 10 according to the first embodiment, the first carrier transporter 105 may include, for example, no first area 1051 between the photoelectric converter 104 and the third area 1053 as illustrated in FIG. 7. In other words, for example, the first carrier transporter 105 may include the third area 1053 between the second area 1052 and the photoelectric converter 104. In this case, the first carrier transporter 105 in the solar cell device 10 according to the first embodiment may have, for example, an energy band structure as illustrated in FIG. 8. In the energy band diagram in FIG. 8, the energy levels in the forbidden band B1051 of the first area 1051 in the energy band diagram in FIG. 4 are eliminated.

The above examples are described using the HOMO level of the first carrier transporter 105, but may be described differently. For example, the HOMO level of the first carrier transporter 105 being relatively lower may be rephrased as the carrier density of the first carrier transporter 105 being relatively higher. The HOMO level of the first carrier transporter 105 being relatively higher may be rephrased as the carrier density of the first carrier transporter 105 being relatively lower.

For example, the first level EL1 of the first carrier transporter 105 being different from the second level EL2 of the first carrier transporter 105 may be rephrased as the carrier density of the first interface area Ab1 along the first surface CF1 being different from the carrier density of the second interface area Ab2 along the second surface CF2 in the first carrier transporter 105. For example, the first level EL1 of the first carrier transporter 105 being lower than the second level EL2 of the first carrier transporter 105 may be rephrased as the carrier density of the first interface area Ab1 along the first surface CF1 being higher than the carrier density of the second interface area Ab2 along the second surface CF2 in the first carrier transporter 105. The HOMO level of the first carrier transporter 105 increasing in the first direction may be rephrased as the carrier density of the first carrier transporter 105 decreasing in the first direction. The HOMO level of the first carrier transporter 105 increasing in the first direction from the first interface area Ab1 to the second interface area Ab2 may be rephrased as the carrier density of the first carrier transporter 105 decreasing in the first direction from the first interface area Ab1 to the second interface area Ab2.

### 1-3. Method for Manufacturing Solar Cell Device 10

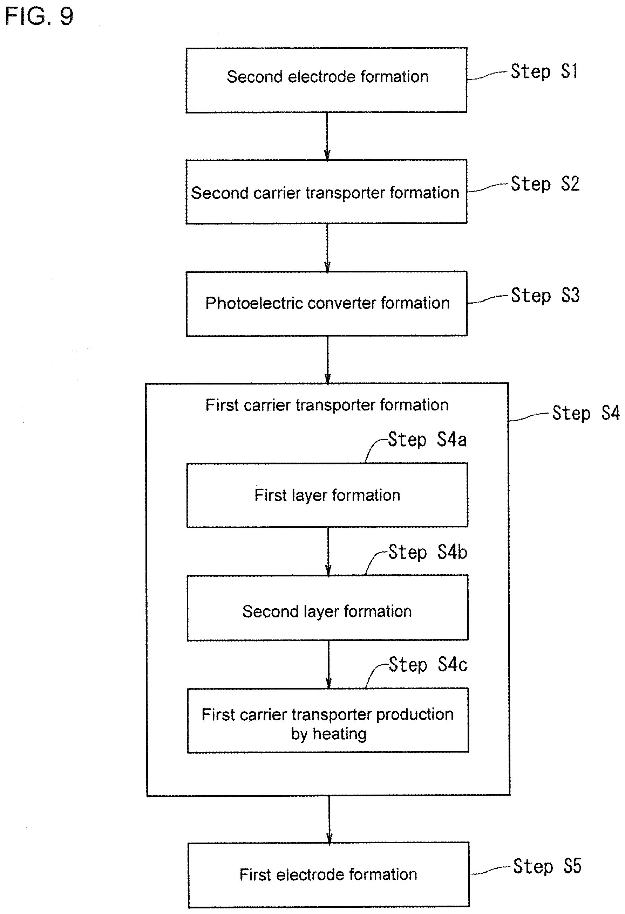

As illustrated in FIG. 9, for example, the solar cell device 10 according to the first embodiment illustrated in, for example, FIG. 1 can be manufactured by performing steps S1 to S5 in this order. For example, step S3 corresponds to forming a photoelectric converter in an aspect of the present disclosure, step S4 corresponds to forming a first carrier transporter on the photoelectric converter in an aspect of the present disclosure, and step S5 corresponds to forming a first electrode on the first carrier transporter in an aspect of the present disclosure.

In step S1, the second electrode 102 is formed on the substrate 101. The second electrode 102 can be formed on the substrate 101 by depositing the material for the second electrode 102 on the substrate 101 with, for example, a vacuum process such as sputtering. The material for the second electrode 102 is, for example, a TCO such as ITO, FTO, or ZnO. When the first electrode 106 transmits light in a specific wavelength range, the material for the second electrode 102 may be, for example, a highly conductive metal such as Au.

In step S2, the second carrier transporter 103 is formed on the second electrode 102. The material for the second carrier transporter 103 is, for example, metal oxide such as TiO₂, SnO₂, ZnO, or In₂O₃. For example, the second carrier transporter 103 may be formed on the second electrode 102 by applying, onto the second electrode 102, a liquid material prepared by dissolving a material such as metal chloride or metal isopropoxide into a polar solution, and hydrolyzing the material to produce the metal oxide. Examples of the metal chloride include titanium chloride, tin chloride, zinc chloride, and indium chloride. Examples of metal isopropoxide include titanium isopropoxide, tin isopropoxide, zinc isopropoxide, and indium isopropoxide. More specifically, for example, a titanium tetrachloride solution is applied onto the second electrode 102 with, for example, spin coating, and dried. The titanium tetrachloride is then hydrolyzed with, for example, heat at about 150 °C on a hot plate to form the second carrier transporter 103 made of TiO₂ on the second electrode 102. The metal oxide may be doped with, for example, an n-type dopant. For example, when the metal oxide is ZnO, the n-type dopant may be an element such as Al or B. In this case, the liquid material may be doped with the n-type dopant.

For example, the second carrier transporter 103 may be made of an organic material. The organic material may be, for example, a fullerene derivative such as [6,6]-phenyl C₆₁-butyric acid methyl ester (PCBM). In this case, for example, a liquid material prepared by dissolving the fullerene derivative into a chlorobenzene solvent may be used. In this example, 1 milliliter (ml) of the liquid material may include, for example, about 5 to 20 milligrams (mg) of the fullerene derivative. In other words, the liquid material may be, for example, a liquid material containing chlorobenzene as a solvent and a fullerene derivative at a concentration of about 5 to 20 mg/ml. The second carrier transporter 103 made of PCBM may be formed on the second electrode 102 by drying and annealing the liquid material applied onto the second electrode 102. For example, the functional group of the organic material used as the material for the second carrier transporter 103 may be changed to change the physical properties and solubility in organic solvents. In this case as well, the organic material may be doped with, for example, an n-type dopant.

In step S3, the photoelectric converter 104 is formed on the second carrier transporter 103. In other words, the photoelectric converter 104 is formed in step S3. In this step, the photoelectric converter 104 may be formed by, for example, applying a liquid material onto the second carrier transporter 103 and annealing the applied liquid material. The liquid material may be prepared by, for example, dissolving alkyl halide amine and lead halide as the materials for the photoelectric converter 104 in the solvent or dissolving alkyl halide amine and tin halide as the materials for the photoelectric converter 104 in the solvent. In this case, the photoelectric converter 104 may be made of a thin film of a halide perovskite semiconductor with a crystal structure.

In step S4, the first carrier transporter 105 is formed on the photoelectric converter 104. The first carrier transporter 105 can be formed on the photoelectric converter 104 by performing, for example, steps S4a, S4b, and S4c in this order. For example, step S4a corresponds to forming a first layer on the photoelectric converter in an aspect of the present disclosure, step S4b corresponds to forming a second layer on the first layer in an aspect of the present disclosure, and step S4c corresponds to forming the first carrier transporter from the first layer and the second layer in an aspect of the present disclosure.

In step S4a, a first layer is formed on the photoelectric converter 104. In step S4b, a second layer is formed on the first layer. In step S4c, the first layer and the second layer are heated to diffuse the dopant contained in the first layer into the second layer. This produces the first carrier transporter 105 from the first layer and the second layer. The first layer has a higher dopant concentration than the second layer. The second layer has a lower dopant concentration than the first layer, or contains no dopants. The second layer contains a material for a semiconductor included in the first carrier transporter 105. The dopant may be a p-type dopant for turning a semiconductor into a p-type semiconductor. The first layer may be a layer containing a material or an element that serves as a dopant in the first carrier transporter 105. The first layer may or may not contain a semiconductor material for a semiconductor in the first carrier transporter 105. The second layer contains the semiconductor material for a semiconductor in the first carrier transporter 105, and may or may not contain the material or element that serves as a dopant in the first carrier transporter 105.

For example, when the first layer contains no semiconductor material for a semiconductor in the first carrier transporter 105, a dopant layer as the first layer is formed on the photoelectric converter 104 in step S4a. The dopant layer may be a layer containing no semiconductor material for a semiconductor in the first carrier transporter 105 and containing the material or element that serves as a dopant in the first carrier transporter 105. In this step, the dopant layer can be formed on the photoelectric converter 104 by, for example, applying a liquid material onto the photoelectric converter 104 and drying or annealing the liquid material. For example, the liquid material may be prepared by dissolving lithium bis(trifluoromethanesulfonyl)imide (LiTFSI) or 4-tert-butylpyridine (TBP) into a chlorobenzene solution. LiTFSI and TBP are materials that serve as the dopant in the first carrier transporter 105.

For example, when the first layer contains the semiconductor material for a semiconductor in the first carrier transporter 105, a heavily doped layer as the first layer is formed on the photoelectric converter 104 in step S4a. The heavily doped layer may be a layer containing the semiconductor material for a semiconductor in the first carrier transporter 105 and the material or element that serves as a dopant in the first carrier transporter 105. In this example, the heavily doped layer can be formed on the photoelectric converter 104 by applying a liquid material onto the photoelectric converter 104 and drying and annealing the liquid material. The semiconductor material for a semiconductor in the first carrier transporter 105 may be, for example, an organic semiconductor material such as spiro-OMeTAD, P3HT, PTAA, or 4-butyl-N,N-diphenylaniline homopolymer (Poly-TPD). For example, the liquid material can be prepared by dissolving spiro-OMeTAD and LiTFSI as the material serving as the dopant in the first carrier transporter 105 into chlorobenzene or dissolving spiro-OMeTAD and TBP as the material serving as the dopant in the first carrier transporter 105 into chlorobenzene. In this example, 1 ml of the liquid material may contain about 10 to 85 mg of spiro-OMeTAD. In other words, for example, a liquid material containing chlorobenzene as a solvent and spiro-OMeTAD at a concentration of about 10 to 85 mg/ml may be used. For example, the liquid material may be prepared by dissolving P3HT and LiTFSI as a material serving as a dopant in the first carrier transporter 105 into dichlorobenzene or dissolving P3HT and TBP as a material serving as a dopant in the first carrier transporter 105 into dichlorobenzene. In this example, 1 ml of the liquid material may contain about 5 to 20 mg of P3HT. In other words, for example, a liquid material containing dichlorobenzene as a solvent and P3HT at a concentration of about 5 to 20 mg/ml may be used. For example, the liquid material may be prepared by dissolving PTAA and LiTFSI as the material serving as the dopant in the first carrier transporter 105 into toluene or dissolving PTAA and TBP as the material serving as the dopant in the first carrier transporter 105 into toluene. In this example, 1 ml of the liquid material may contain about 5 to 20 mg of PTAA. In other words, for example, a liquid material containing toluene as a solvent and PTAA at a concentration of 5 to 20 mg/ml may be used. For example, the liquid material may be prepared by dissolving Poly-TPD and LiTFSI as the material serving as the dopant in the first carrier transporter 105 into chlorobenzene or dissolving Poly-TPD and TBP as the material serving as the dopant in the first carrier transporter 105 into chlorobenzene. In this example, 1 ml of the liquid material may contain about 5 to 20 of Poly-TPD. In other words, for example, a liquid material containing chlorobenzene as a solvent and Poly-TPD at a concentration of 5 to 20 mg/ml may be used.

For example, when the second layer contains the material or element that serves as a dopant in the first carrier transporter 105, a lightly doped layer as the second layer is formed on the first layer in step S4b. The lightly doped layer may be a layer containing the semiconductor material for a semiconductor in the first carrier transporter 105 and the material or element that serves as a dopant in the first carrier transporter 105. For example, when the first layer is a heavily doped layer, the lightly doped layer as the second layer is a layer with a lower concentration of the material or element that serves as a dopant in the first carrier transporter 105 than the heavily doped layer. For example, the lightly doped layer can be formed on the first layer by applying a liquid material onto the first layer and drying the liquid material. The semiconductor material for a semiconductor in the first carrier transporter 105 may be, for example, an organic semiconductor material such as spiro-OMeTAD, P3HT, PTAA, or Poly-TPD. For example, the liquid material can be prepared by dissolving spiro-OMeTAD and LiTFSI as the material serving as the dopant in the first carrier transporter 105 into chlorobenzene or dissolving spiro-OMeTAD and TBP as the material serving as the dopant in the first carrier transporter 105 into chlorobenzene. In this example, a liquid material containing chlorobenzene as a solvent and spiro-OMeTAD at a concentration of about 10 to 85 mg/ml may be used. For example, the liquid material may be prepared by dissolving P3HT and LiTFSI as a material serving as a dopant in the first carrier transporter 105 into dichlorobenzene or dissolving P3HT and TBP as a material serving as a dopant in the first carrier transporter 105 into dichlorobenzene. In this example, a liquid material containing dichlorobenzene as a solvent and P3HT at a concentration of about 5 to 20 mg/ml may be used. For example, the liquid material may be prepared by dissolving PTAA and LiTFSI as the material serving as the dopant in the first carrier transporter 105 into toluene or dissolving PTAA and TBP as the material serving as the dopant in the first carrier transporter 105 into toluene. In this example, a liquid material containing toluene as a solvent and PTAA at a concentration of about 5 to 20 mg/ml may be used. For example, the liquid material may be prepared by dissolving Poly-TPD and LiTFSI as the material serving as the dopant in the first carrier transporter 105 into chlorobenzene or dissolving Poly-TPD and TBP as the material serving as the dopant in the first carrier transporter 105 into chlorobenzene. In this example, a liquid material containing chlorobenzene as a solvent and Poly-TPD at a concentration of 5 to 20 mg/ml may be used.

For example, when the second layer contains no material or element that serves as a dopant in the first carrier transporter 105, an undoped layer as the second layer is formed on the first layer in step S4b. The undoped layer may be a layer containing the semiconductor material for a semiconductor in the first carrier transporter 105 and containing no material or element that serves as a dopant in the first carrier transporter 105. For example, when the first layer is a heavily doped layer, the undoped layer as the second layer is a layer without a material or an element that serves as a dopant in the first carrier transporter 105, as compared with the heavily doped layer. For example, the undoped layer can be formed on the first layer by applying a liquid material onto the first layer and drying the liquid material. The semiconductor material for a semiconductor in the first carrier transporter 105 may be, for example, an organic semiconductor material such as spiro-OMeTAD, P3HT, PTAA, or Poly-TPD. In this example, the liquid material can be prepared by dissolving spiro-OMeTAD into chlorobenzene. In this example, a liquid material containing chlorobenzene as a solvent and spiro-OMeTAD at a concentration of about 10 to 85 mg/ml may be used. For example, the liquid material may be prepared by dissolving P3HT into dichlorobenzene. In this example, a liquid material containing dichlorobenzene as a solvent and P3HT at a concentration of about 5 to 20 mg/ml may be used. For example, the liquid material may be prepared by dissolving PTAA into toluene. In this example, a liquid material containing toluene as a solvent and PTAA at a concentration of about 5 to 20 mg/ml may be used. For example, the liquid material may be prepared by dissolving Poly-TPD into chlorobenzene. In this example, a liquid material containing chlorobenzene as a solvent and Poly-TPD at a concentration of 5 to 20 mg/ml may be used.

In step S4c, the first layer and the second layer are heated to diffuse the dopant contained in the first layer into the second layer. This produces the first carrier transporter 105 from the first layer and the second layer. In this example, heating of the first layer and the second layer may be annealing of the first layer and the second layer. The temperature and the time for heating the first layer and the second layer may be set as appropriate based on, for example, the semiconductor material and the dopant material in the first layer and the second layer. For example, when the first layer is a dopant layer containing no semiconductor material for a semiconductor in the first carrier transporter 105, the semiconductor material for a semiconductor in the first carrier transporter 105 may diffuse from the second layer toward the first layer.

In step S5, the first electrode 106 is formed on the first carrier transporter 105. The first electrode 106 can be formed by depositing the material for the first electrode 106 on the first carrier transporter 105 with, for example, a vacuum process such as sputtering. The material for the first electrode 106 is, for example, a highly conductive metal such as Au or a TCO such as ITO, FTO, or ZnO. The first electrode 106 may be formed by, for example, applying a metal paste as a coating liquid by, for example, screen printing and drying the applied metal paste until the metal paste solidifies.

In step S4, for example, the first layer may be a dopant layer or a heavily doped layer, and the second layer may be a lightly doped layer or an undoped layer. The thickness of each of the first layer and the second layer and the temperature and time conditions for heating the first layer and the second layer may be set as appropriate. This allows formation of the first carrier transporter 105 in which, for example, the dopant concentration decreases in the negative Z-direction as the first direction from the first interface area Ab1 along the first surface CF1 to the second interface area Ab2 along the second surface CF2. In other words, for example, the first carrier transporter 105 may have the HOMO level increasing in the negative Z-direction as the first direction from the first interface area Ab1 along the first surface CF1 to the second interface area Ab2 along the second surface CF2. In this case, for example, the first carrier transporter 105 may have an energy band structure as illustrated in FIG. 2. In other words, in the first carrier transporter 105, for example, the first level EL1 that is the HOMO level of the first interface area Ab1 may be lower than the second level EL2 that is the HOMO level of the second interface area Ab2. In the first carrier transporter 105, for example, the HOMO level may increase in the negative Z-direction as the first direction from the first interface area Ab1 to the second interface area Ab2. For example, the semiconductor material in the first carrier transporter 105 and the dopant concentration in the dopant layer or the heavily doped layer as the first layer may be set as appropriate to cause the first level EL1 that is the HOMO level of the first interface area Ab1 to be substantially the same as the third level EL3 that is the VBM level of the photoelectric converter 104. For example, the semiconductor material in the first carrier transporter 105 and the dopant concentration in the lightly doped layer or the undoped layer as the second layer may be set as appropriate to cause the second level EL2 that is the HOMO level of the second interface area Ab2 to be substantially the same as the fourth level EL4 that is the Fermi level of the first electrode 106.

In step S4, for example, the first layer may be a heavily doped layer, and the second layer may be a lightly doped layer or an undoped layer. The thickness of each of the first layer and the second layer and the temperature and time conditions for heating the first layer and the second layer may be set as appropriate. This may allow formation of, for example, the first carrier transporter 105 including the first area 1051 as illustrated in FIGs. 3 and 5. For example, the semiconductor material in the first carrier transporter 105 and the dopant concentration in the heavily doped layer as the first layer may be set as appropriate to cause the HOMO level of the first area 1051 to be substantially the same as the third level EL3 that is the VBM level of the photoelectric converter 104. For example, the temperature and time conditions for heating the first layer and the second layer may also be set as appropriate to form the first carrier transporter 105 including the first area 1051, the second area 1052, and the third area 1053 as illustrated in FIG. 3 or to form the first carrier transporter 105 including the first area 1051 and the third area 1053 as illustrated in FIG. 5. As illustrated in FIG. 3, when the first carrier transporter 105 including the first area 1051, the second area 1052, and the third area 1053 is formed, for example, the first carrier transporter 105 may have an energy band structure as illustrated in FIG. 4. In this case, for example, the semiconductor material in the first carrier transporter 105 and the dopant concentration in the lightly doped layer or the undoped layer as the second layer may be set as appropriate to cause the HOMO level of the second area 1052 to be substantially the same as the fourth level EL4 that is the Fermi level of the first electrode 106. As illustrated in FIG. 5, when the first carrier transporter 105 including the first area 1051 and the third area 1053 is formed, for example, the first carrier transporter 105 may have an energy band structure as illustrated in FIG. 6. In this case, for example, the semiconductor material in the first carrier transporter 105 and the dopant concentration in the lightly doped layer or the undoped layer as the second layer may be set as appropriate to cause the second level EL2 that is the HOMO level of the second interface area Ab2 to be substantially the same as the fourth level EL4 that is the Fermi level of the first electrode 106.

In step S4, for example, the first layer may be a dopant layer or a heavily doped layer, and the second layer may be a lightly doped layer or an undoped layer. The thickness of each of the first layer and the second layer and the temperature and time conditions for heating the first layer and the second layer may be set as appropriate. This may allow formation of, for example, the first carrier transporter 105 including the second area 1052 as illustrated in FIG. 7. For example, the semiconductor material in the first carrier transporter 105 and the dopant concentration in the lightly doped layer or the undoped layer as the second layer may be set as appropriate to cause the HOMO level of the second area 1052 to be substantially the same as the fourth level EL4 that is the Fermi level of the first electrode 106. For example, the semiconductor material in the first carrier transporter 105 and the dopant concentration in the dopant layer or the heavily doped layer as the first layer may be set as appropriate to cause the first level EL1 that is the HOMO level of the first interface area Ab1 to be substantially the same as the third level EL3 that is the VBM level of the photoelectric converter 104.

### 1-4. Solar Cell Module 1

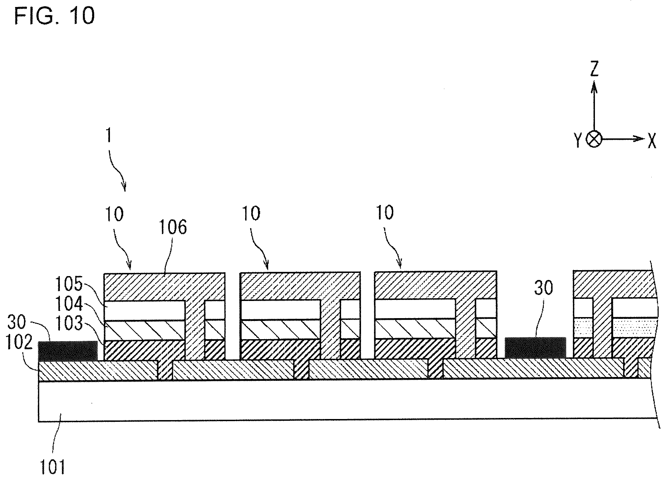

As illustrated in FIG. 10, for example, a solar cell module 1 includes multiple solar cell devices 10 and a current collector 30. In the solar cell module 1 according to the first embodiment, the multiple solar cell devices 10 share a single substrate 101. In other words, in the solar cell module 1 according to the first embodiment, multiple second electrodes 102 are formed on the single substrate 101.

The current collector 30 serves as an output electrode. The current collector 30 may be, for example, an aluminum wire or a copper wire. The current collector 30 is connected to, for example, a terminal for receiving electricity generated in the solar cell devices 10.

### 2. Other Embodiments

The present disclosure is not limited to the above first embodiment and may be changed or altered variously without departing from the spirit and scope of the present disclosure.

### 2-1. Second Embodiment

A second embodiment will be described below focusing on differences from the first embodiment.

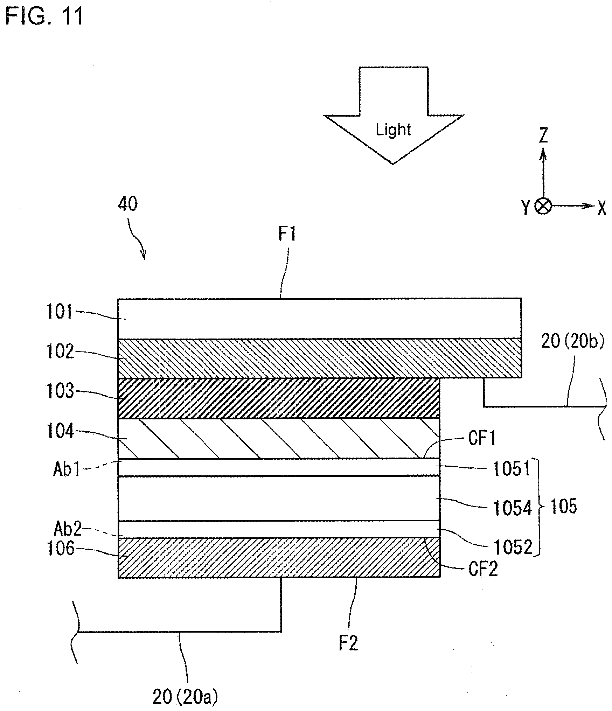

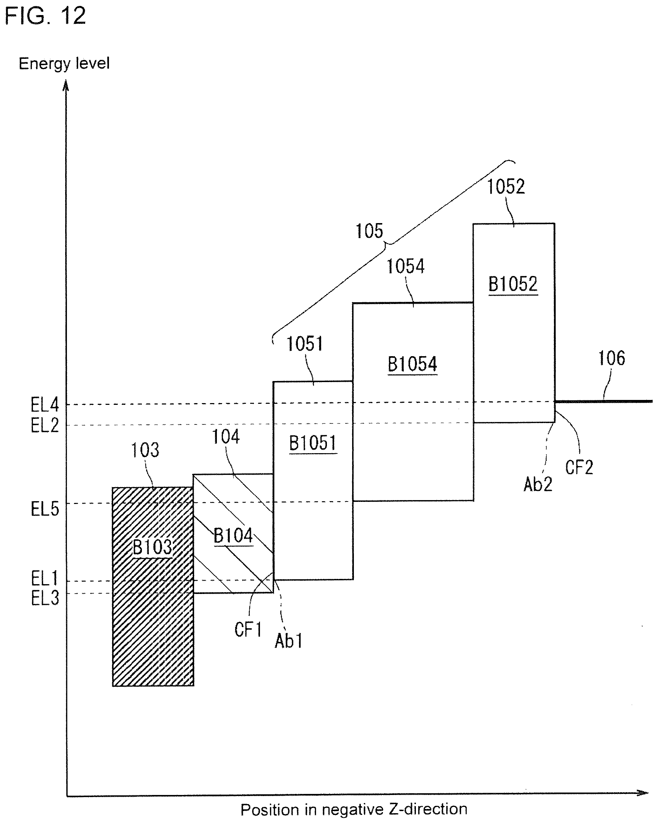

FIG. 11 is a schematic sectional view of a solar cell device 40 with a first example structure according to a second embodiment. FIG. 12 is an energy band diagram illustrating a first example relationship between the energy levels of a first electrode 106, a first carrier transporter 105, a photoelectric converter 104, and a second carrier transporter 103 in the solar cell device 40 according to the second embodiment.

As illustrated in FIG. 11, the solar cell device 40 according to the second embodiment includes, on the basis of an example structure of the solar cell device 10 according to the first embodiment illustrated in FIG. 3, the first carrier transporter 105 including a fourth area 1054 in place of the third area 1053. The fourth area 1054 is located between the first area 1051 and the second area 1052. In this case, the first carrier transporter 105 in the solar cell device 40 according to the second embodiment may have, for example, an energy band structure as illustrated in FIG. 12. The energy band diagram in FIG. 12 illustrates, on the basis of the energy band diagram in FIG. 4, the energy levels in a forbidden band B1054 of the fourth area 1054 in place of the energy levels in the forbidden band B1053 of the third area 1053. The HOMO level of the fourth area 1054 is substantially the same as a fifth level EL5 that is an energy level between the first level EL1 and the second level EL2. In other words, in the fourth area 1054 of the first carrier transporter 105, the HOMO level is substantially the same as the fifth level EL5 from the first area 1051 to the second area 1052 by a fourth predetermined thickness. In still other words, the HOMO level of the fourth area 1054 is substantially the same as the fifth level EL5 in the negative Z-direction as the first direction. In this case, the HOMO level of the first carrier transporter 105 increases discretely from the first surface CF1 to the second surface CF2. In other words, the HOMO level of the first carrier transporter 105 increases discretely from the first interface area Ab1 along the first surface CF1 to the second interface area Ab2 along the second surface CF2. More specifically, the HOMO level of the first carrier transporter 105 increases stepwise from the first surface CF1 to the second surface CF2. In other words, the HOMO level of the first carrier transporter 105 increases stepwise from the first interface area Ab1 along the first surface CF1 to the second interface area Ab2 along the second surface CF2. Note that the difference between the first level EL1 and the fifth level EL5 may or may not be the same as the difference between the second level EL2 and the fifth level EL5.

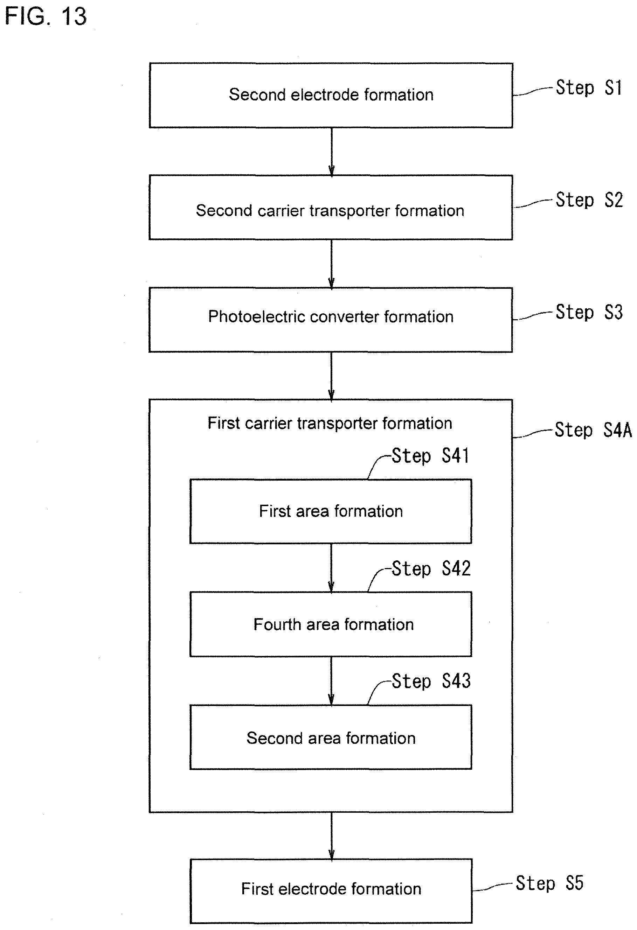

In the second embodiment, the solar cell device 40 illustrated in FIG. 11 may be formed by performing, for example, steps S1 to S3 described above in this order as in the first embodiment before performing step S4A, and further performing step S5 described above as in the first embodiment as illustrated in FIG. 13. In step S4A, steps S41, S42, and S43 are performed in this order.

In step S41, the first area 1051 of the first carrier transporter 105 is formed on the photoelectric converter 104. For example, the first area 1051 may be formed on the photoelectric converter 104 by applying a second-A liquid material onto the photoelectric converter 104 and drying and annealing the applied second-A liquid material. The material for the second-A liquid material may be, for example, an organic semiconductor material, such as spiro-OMeTAD, P3HT, PTAA, or Poly-TPD, doped with a dopant. The second-A liquid material has a higher dopant concentration than either a second-B liquid material or a second-C liquid material (described later). The dopant may be, for example, LiTFSI or TBP.

In step S42, the fourth area 1054 of the first carrier transporter 105 is formed on the first area 1051 of the first carrier transporter 105. For example, the fourth area 1054 can be formed on the first area 1051 by applying the second-B liquid material onto the first area 1051 and drying and annealing the applied second-B liquid material. The material for the second-B liquid material may be, for example, an organic semiconductor material, such as spiro-OMeTAD, P3HT, PTAA, or Poly-TPD, doped with a dopant. The second-B liquid material has a higher dopant concentration than the second-C liquid material (described later). The dopant may be, for example, LiTFSI or TBP.

In step S43, the second area 1052 of the first carrier transporter 105 is formed on the fourth area 1054 of the first carrier transporter 105. For example, the second area 1052 can be formed on the fourth area 1054 by applying the second-C liquid material onto the fourth area 1054 and drying and annealing the applied second-C liquid material. The material for the second-C liquid material may be, for example, an organic semiconductor material, such as spiro-OMeTAD, P3HT, PTAA, or Poly-TPD, doped with a dopant. The dopant may be, for example, LiTFSI or TBP.

The first carrier transporter 105 with the structure described above allows control of the thicknesses of the first area 1051 and the second area 1052 without controlling the conditions for dopant diffusion. Thus, the thickness of each of the first area 1051 and the second area 1052 can be more easily controlled in a thicker first carrier transporter 105.

Note that, although the first carrier transporter 105 according to the second embodiment described above includes three areas of the first area 1051, the fourth area 1054, and the second area 1052, the first carrier transporter 105 is not limited to this structure. For example, the first carrier transporter 105 may include, between the first area 1051 and the second area 1052, multiple areas having different HOMO levels within a range between the first level EL1 and the second level EL2.

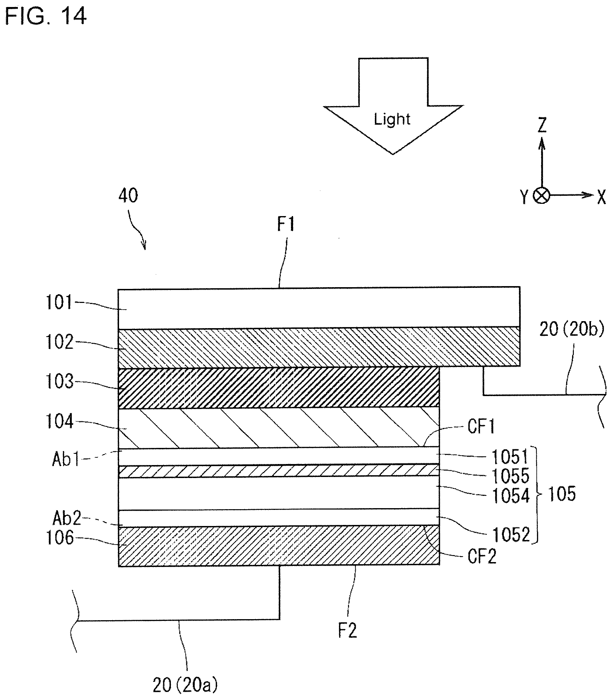

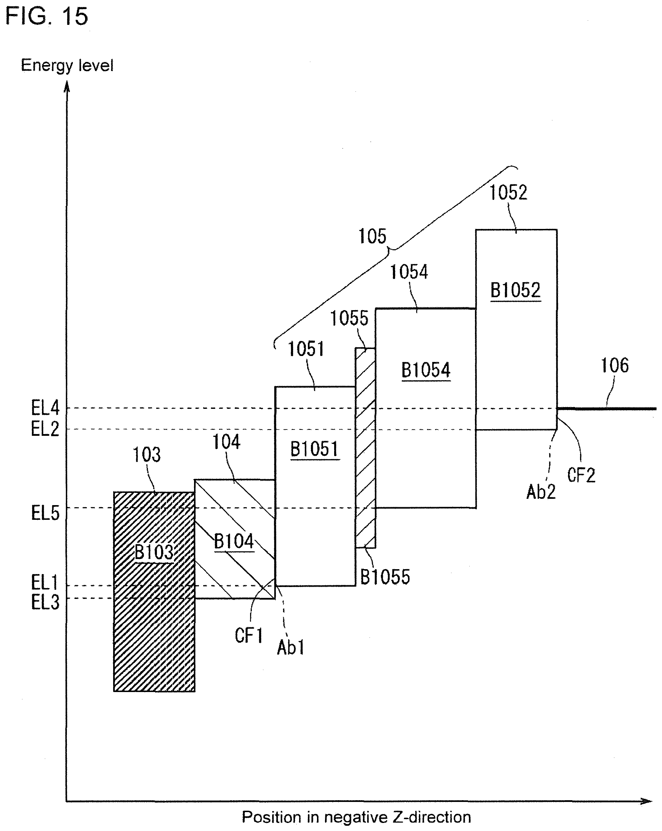

As illustrated in, for example, FIG. 14, the first carrier transporter 105 in the solar cell device 40 according to the second embodiment may include a first interface layer 1055 located between the first area 1051 and the fourth area 1054. In this case, for example, the first area 1051 and the fourth area 1054 may be made of different materials, and one or more of the materials for the first area 1051 and the fourth area 1054 may deteriorate due to contact between the material for the first area 1051 and the material for the fourth area 1054. Such deterioration may be reduced with the first interface layer 1055. In this case, the first carrier transporter 105 in the solar cell device 40 according to the second embodiment may have, for example, an energy band structure as illustrated in FIG. 15. The energy band diagram in FIG. 15 has, on the basis of the energy band diagram in FIG. 12, the energy levels in a forbidden band B1055 of the first interface layer 1055 between the energy levels in the forbidden band B1051 of the first area 1051 and the energy levels in the forbidden band B1054 of the fourth area 1054. For example, as illustrated in FIG. 15, the HOMO level of the first interface layer 1055 is higher than or equal to the HOMO level of the first area 1051 and lower than or equal to the HOMO level of the fourth area 1054. In other words, the HOMO level of the first interface layer 1055 is higher than or equal to the first level EL1 that is substantially the same as the HOMO level of the first area 1051 and is lower than or equal to the fifth level EL5 that is substantially the same as the HOMO level of the fourth area 1054. The material for the first interface layer 1055 may be, for example, a material that transmits light in a specific wavelength range. The material for the first interface layer 1055 may be, for example, a TCO or a material used for buffer layers in tandem solar cells. The first interface layer 1055 may be formed by, for example, applying a liquid material containing the material for the first interface layer 1055 onto the first area 1051 and drying and annealing the applied liquid material. The first interface layer 1055 may be formed with, for example, a vacuum process such as sputtering.

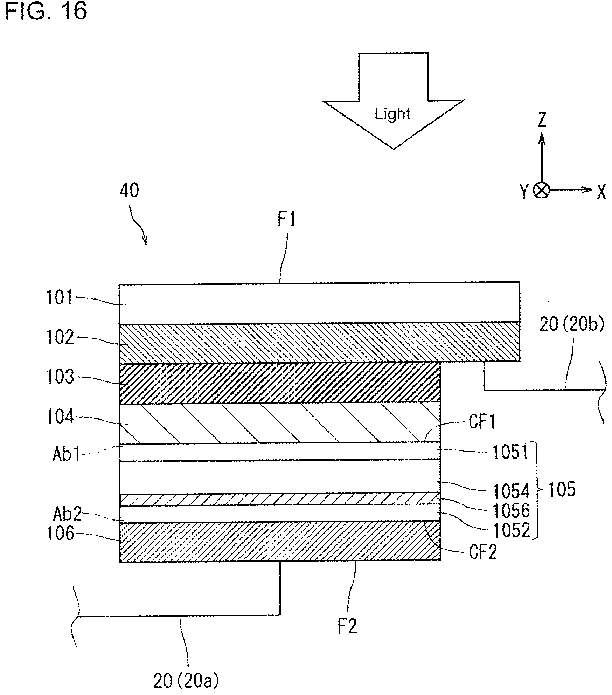

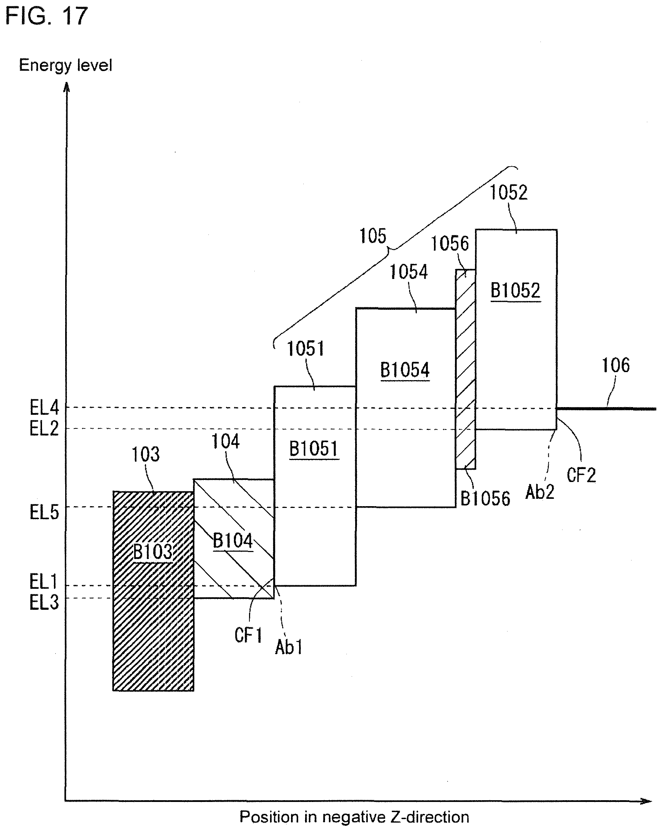

As illustrated in FIG. 16, for example, the first carrier transporter 105 in the solar cell device 40 according to the second embodiment may include a second interface layer 1056 located between the second area 1052 and the fourth area 1054. In this case, for example, the second area 1052 and the fourth area 1054 may be made of different materials, and one or more of the materials for the second area 1052 and the fourth area 1054 may deteriorate due to contact between the material for the second area 1052 and the material for the fourth area 1054. Such deterioration may be reduced with the second interface layer 1056. In this case, the first carrier transporter 105 in the solar cell device 40 according to the second embodiment may have, for example, an energy band structure as illustrated in FIG. 17. The energy band diagram in FIG. 17 has, on the basis of the energy band diagram in FIG. 12, the energy levels in a forbidden band B1056 of the second interface layer 1056 between the energy levels in the forbidden band B1052 of the second area 1052 and the energy levels in the forbidden band B1054 of the fourth area 1054. As illustrated in FIG. 17, for example, the HOMO level of the second interface layer 1056 may be higher than or equal to the HOMO level of the fourth area 1054 and lower than or equal to the HOMO level of the second area 1052. In other words, the HOMO level of the second interface layer 1056 may be higher than or equal to the fifth level EL5 that is substantially the same as the HOMO level of the fourth area 1054 and lower than or equal to the second level EL2 that is substantially the same as the HOMO level of the second area 1052. The material for the second interface layer 1056 may be, for example, a material that transmits light in a specific wavelength range. The material for the second interface layer 1056 may be, for example, a TCO or a material used for buffer layers in tandem solar cells. The second interface layer 1056 may be formed by, for example, applying a liquid material containing the material for the second interface layer 1056 onto the fourth area 1054 and drying and annealing the applied liquid material. The second interface layer 1056 may be formed with, for example, a vacuum process such as sputtering.

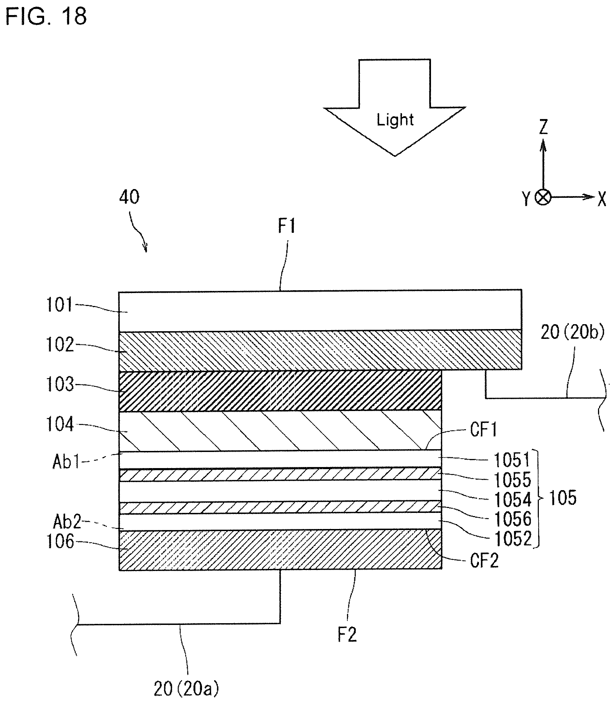

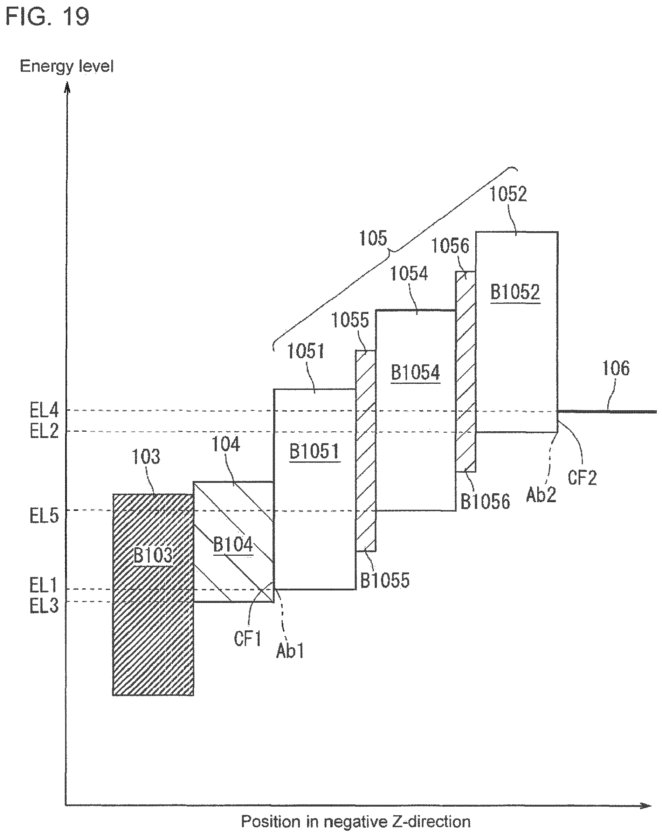

As illustrated in FIG. 18, for example, the first carrier transporter 105 in the solar cell device 40 according to the second embodiment may include the first interface layer 1055 and the second interface layer 1056 described above. The first interface layer 1055 is located between the first area 1051 and the fourth area 1054. The second interface layer 1056 is located between the second area 1052 and the fourth area 1054. In this case, the first carrier transporter 105 in the solar cell device 40 according to the second embodiment may have, for example, an energy band structure as illustrated in FIG. 19. The energy band diagram in FIG. 19 has, on the basis of the energy band diagram in FIG. 12, the energy levels in the forbidden band B1055 of the first interface layer 1055 between the energy levels in the forbidden band B1051 of the first area 1051 and the energy levels in the forbidden band B1054 of the fourth area 1054 and has the energy levels in the forbidden band B1056 of the second interface layer 1056 between the energy levels in the forbidden band B1052 of the second area 1052 and the energy levels in the forbidden band B1054 of the fourth area 1054. As illustrated in FIG. 19, for example, the HOMO level of the first interface layer 1055 may be higher than or equal to the HOMO level of the first area 1051 and lower than or equal to the HOMO level of the fourth area 1054. In other words, the HOMO level of the first interface layer 1055 is higher than or equal to the first level EL1 that is substantially the same as the HOMO level of the first area 1051 and is lower than or equal to the fifth level EL5 that is substantially the same as the HOMO level of the fourth area 1054. As illustrated in FIG. 19, for example, the HOMO level of the second interface layer 1056 may be higher than or equal to the HOMO level of the fourth area 1054 and lower than or equal to the HOMO level of the second area 1052. In other words, the HOMO level of the second interface layer 1056 may be higher than or equal to the fifth level EL5 that is substantially the same as the HOMO level of the fourth area 1054 and lower than or equal to the second level EL2 that is substantially the same as the HOMO level of the second area 1052.

### 2-2. Other Embodiments

The third level EL3 is the VBM level of the photoelectric converter 104 in the first and second embodiments described above, but is not limited to this example. For example, when the photoelectric converter 104 uses an i-type semiconductor that is an organic semiconductor, the third level EL3 may be the energy level of the HOMO (the HOMO level) of the photoelectric converter 104.

Although the present disclosure has been described with reference to various drawings and embodiments, those skilled in the art can perform various variations and alternations based on the present disclosure. Such variations and alterations also fall within the scope of the present disclosure. For example, the functions of the functional units and steps are reconfigurable unless any contradiction arises logically. Multiple functional units or steps may be combined into a single unit or step, or may be divided into separate units or steps. The present disclosure is not limited to exact implementation of the embodiments described above. Some of the features of the embodiments may be combined as appropriate or may be eliminated.

### 2-3. Overview of Present Disclosure

The present disclosure provides the structures described below.

In one embodiment, (1) a solar cell device includes a first electrode, a photoelectric converter, and a first carrier transporter between the first electrode and the photoelectric converter. In the first carrier transporter, a first level being an energy level of a highest occupied molecular orbital of a first surface in contact with the photoelectric converter is lower than a second level being an energy level of a highest occupied molecular orbital of a second surface in contact with the first electrode.
(2) In the solar cell device according to (1), an energy level of a highest occupied molecular orbital of the first carrier transporter increases from the first surface to the second surface in a first direction from the first surface toward the second surface.
(3) In the solar cell device according to (1) or (2), the first level is substantially same as a third level being an energy level of an upper end of a valence band of the photoelectric converter.
(4) In the solar cell device according to any one of (1) to (3), the second level is substantially same as a fourth level being a Fermi level of the first electrode.
(5) In the solar cell device according to any one of (1) to (4), the first carrier transporter includes a first area having a first predetermined thickness from the first surface in the first direction. An energy level of a highest occupied molecular orbital of the first area in the first carrier transporter is substantially same as the third level.
(6) In the solar cell device according to any one of (1) to (5), the first carrier transporter includes a second area having a second predetermined thickness from the second surface in a direction opposite to the first direction. An energy level of a highest occupied molecular orbital of the second area in the first carrier transporter is substantially same as the fourth level.
(7) In the solar cell device according to any one of (1) to (6), the first carrier transporter includes a third area between the first area and the first electrode. An energy level of a highest occupied molecular orbital of the third area in the first carrier transporter increases in the first direction.
(8) In the solar cell device according to any one of (1) to (7), the first carrier transporter further includes a fourth area between the first area and the second area. An energy level of a highest occupied molecular orbital of the fourth area in the first carrier transporter is substantially same as a fifth level being an energy level greater than or equal to the first level and less than or equal to the second level.
(9) In the solar cell device according to any one of (1) to (8), the first carrier transporter includes a first interface layer between the first area and the fourth area and a second interface layer between the second area and the fourth area.

In one embodiment, (10) a solar cell module includes a first electrode, a photoelectric converter, and a first carrier transporter between the first electrode and the photoelectric converter. In the first carrier transporter, a first level being an energy level of a highest occupied molecular orbital of a first surface in contact with the photoelectric converter is lower than a second level being an energy level of a highest occupied molecular orbital of a second surface in contact with the first electrode.
(11) In the solar cell module according to (10), an energy level of a highest occupied molecular orbital of the first carrier transporter increases from the first surface to the second surface in a first direction from the first surface toward the second surface.
(12) In the solar cell module according to (10) or (11), the first level is substantially same as a third level being an energy level of an upper end of a valence band of the photoelectric converter.
(13) In the solar cell module according to any one of (10) to (12), the second level is substantially same as a fourth level being a Fermi level of the first electrode.
(14) In the solar cell module according to any one of (10) to (13), the first carrier transporter includes a first area having a first predetermined thickness from the first surface in the first direction. An energy level of a highest occupied molecular orbital of the first area in the first carrier transporter is substantially same as the third level.
(15) In the solar cell module according to any one of (10) to (14), the first carrier transporter includes a second area having a second predetermined thickness from the second surface in a direction opposite to the first direction. An energy level of a highest occupied molecular orbital of the second area in the first carrier transporter is substantially same as the fourth level.
(16) In the solar cell module according to any one of (10) to (15), the first carrier transporter includes a third area between the first area and the first electrode. An energy level of a highest occupied molecular orbital of the third area in the first carrier transporter increases in the first direction.
(17) In the solar cell module according to any one of (10) to (16), the first carrier transporter further includes a fourth area between the first area and the second area. An energy level of a highest occupied molecular orbital of the fourth area in the first carrier transporter is substantially same as a fifth level being an energy level greater than or equal to the first level and less than or equal to the second level.
(18) In the solar cell module according to any one of (10) to (17), the first carrier transporter includes a first interface layer between the first area and the fourth area and a second interface layer between the second area and the fourth area.

In one embodiment, (11) a method for manufacturing a solar cell device includes forming a photoelectric converter, forming a dopant layer on the photoelectric converter, forming a first carrier transporter on the dopant layer, and forming a first electrode on the first carrier transporter.

### REFERENCE SIGNS

- 1: solar cell module
- 10: solar cell device
- 101: substrate
- 102: second electrode
- 103: second carrier transporter
- 104: photoelectric converter
- 105: first carrier transporter
- 1051: first area
- 1052: second area
- 1053: third area
- 1054: fourth area
- 1055: first interface layer
- 1056: second interface layer
- 106: first electrode
- F1: first device surface
- F2: second device surface
- CF1: first surface
- CF2: second surface
- EL1: first level
- EL2: second level
- EL3: third level
- EL4: fourth level
- EL5: fifth level
- 20: wire
- 30: current collector
- 40: solar cell device

## Claims

1. A solar cell device, comprising:
a first electrode;
a photoelectric converter; and
a first carrier transporter between the first electrode and the photoelectric converter,
wherein the first carrier transporter includes a first surface in contact with the photoelectric converter and a second surface in contact with the first electrode, and
in the first carrier transporter, a first level being an energy level of a highest occupied molecular orbital of a first interface area along the first surface is lower than a second level being an energy level of a highest occupied molecular orbital of a second interface area along the second surface.

2. The solar cell device according to claim 1, wherein
an energy level of a highest occupied molecular orbital of the first carrier transporter increases from the first interface area to the second interface area in a first direction from the first surface toward the second surface.

3. The solar cell device according to claim 1 or claim 2, wherein
the first level is substantially same as a third level being an energy level of an upper end of a valence band of the photoelectric converter.

4. The solar cell device according to claim 3, wherein
the first carrier transporter includes a first area along the first surface,
the first area has a first predetermined thickness from the first surface in a first direction from the first surface toward the second surface, and
an energy level of a highest occupied molecular orbital of the first area is substantially same as the third level.

5. The solar cell device according to claim 4, wherein
the first carrier transporter includes a third area between the first area and the first electrode, and
an energy level of a highest occupied molecular orbital of the third area increases in the first direction.

6. The solar cell device according to any one of claims 1 to 3, wherein
the second level is substantially same as a fourth level being a Fermi level of the first electrode.

7. The solar cell device according to claim 6, wherein
the first carrier transporter includes a second area along the second surface,
the second area has a second predetermined thickness from the second surface in a second direction opposite to a first direction from the first surface toward the second surface, and
an energy level of a highest occupied molecular orbital of the second area is substantially same as the fourth level.

8. The solar cell device according to claim 7, wherein
the first carrier transporter includes a third area between the second area and the photoelectric converter, and
an energy level of a highest occupied molecular orbital of the third area increases in the first direction.

9. The solar cell device according to claim 4, wherein
the second level is substantially same as a fourth level being a Fermi level of the first electrode.

10. The solar cell device according to claim 9, wherein
the first carrier transporter includes a second area along the second surface,
the second area has a second predetermined thickness from the second surface in a second direction opposite to the first direction, and
an energy level of a highest occupied molecular orbital of the second area is substantially same as the fourth level.

11. The solar cell device according to claim 10, wherein
the first carrier transporter includes a third area between the first area and the second area, and
an energy level of a highest occupied molecular orbital of the third area increases in the first direction.

12. The solar cell device according to claim 10, wherein
the first carrier transporter further includes a fourth area between the first area and the second area, and
an energy level of a highest occupied molecular orbital of the fourth area is substantially same as a fifth level being an energy level between the first level and the second level.

13. The solar cell device according to claim 12, wherein
the first carrier transporter includes a first interface layer between the first area and the fourth area, and
an energy level of a highest occupied molecular orbital of the first interface layer is higher than or equal to the energy level of the highest occupied molecular orbital of the first area, and is lower than or equal to the energy level of the highest occupied molecular orbital of the fourth area.

14. The solar cell device according to claim 12 or claim 13, wherein
the first carrier transporter includes a second interface layer between the second area and the fourth area, and
an energy level of a highest occupied molecular orbital of the second interface layer is higher than or equal to the energy level of the highest occupied molecular orbital of the fourth area, and is lower than or equal to the energy level of the highest occupied molecular orbital of the second area.

15. A solar cell device, comprising:
a first electrode;
a photoelectric converter; and
a first carrier transporter between the first electrode and the photoelectric converter,
wherein the first carrier transporter includes a first surface in contact with the photoelectric converter and a second surface in contact with the first electrode, and
in the first carrier transporter, a carrier density in a first interface area along the first surface is greater than a carrier density in a second interface area along the second surface.

16. A solar cell module, comprising:
a first electrode;
a photoelectric converter; and
a first carrier transporter between the first electrode and the photoelectric converter,
wherein the first carrier transporter includes a first surface in contact with the photoelectric converter and a second surface in contact with the first electrode, and
in the first carrier transporter, a first level being an energy level of a highest occupied molecular orbital of a first interface area along the first surface is lower than a second level being an energy level of a highest occupied molecular orbital of a second interface area along the second surface.

17. A method for manufacturing a solar cell device, the method comprising:
forming a photoelectric converter;
forming a first carrier transporter on the photoelectric converter; and
forming a first electrode on the first carrier transporter,
wherein the forming the first carrier transporter includes
forming a first layer on the photoelectric converter,
forming a second layer on the first layer, and
heating the first layer and the second layer to diffuse a dopant contained in the first layer into the second layer to produce the first carrier transporter from the first layer and the second layer,
the first layer has a higher dopant concentration than the second layer, and
the second layer has a lower dopant concentration than the first layer or contains no dopant, and the second layer contains a material for a semiconductor included in the first carrier transporter.
